(19) Europäisches Patentamt
European Patent Office
Office européen des brevets

(11) EP 2 719 716 A1

(12) **EUROPEAN PATENT APPLICATION**
published in accordance with Art. 153(4) EPC

(43) Date of publication:
**16.04.2014 Bulletin 2014/16**

(21) Application number: **12797135.6**

(22) Date of filing: **07.06.2012**

(51) Int Cl.:
*C08J 5/18 (2006.01)* *H01L 31/042 (2014.01)*
*H05K 1/03 (2006.01)*

(86) International application number:
**PCT/JP2012/064699**

(87) International publication number:
**WO 2012/169591 (13.12.2012 Gazette 2012/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.06.2011 JP 2011129417**
**29.08.2011 JP 2011186505**
**01.05.2012 JP 2012104814**

(71) Applicants:
- **Sumitomo Seika Chemicals Co., Ltd.**
**Kako-gun Hyogo 675-0145 (JP)**
- **National Institute of Advanced Industrial Science and Technology**
**Tokyo 100-8921 (JP)**
- **Tokyo University Of Science Educational Foundation Administrative Organization**
**Shinjuku-ku**
**Tokyo 162-8601 (JP)**

(72) Inventors:
- **BANDO Seiji**
**Kako-gun**
**Hyogo 675-0145 (JP)**
- **HAYASHIZAKA Noriyuki**
**Kako-gun**
**Hyogo 675-0145 (JP)**
- **UMEDA Yuki**
**Kako-gun**
**Hyogo 675-0145 (JP)**
- **KAWASAKI Kazunori**
**Sendai-shi**
**Miyagi 983-8551 (JP)**
- **EBINA Takeo**
**Sendai-shi**
**Miyagi 983-8551 (JP)**
- **HAYASHI Hiromichi**
**Sendai-shi**
**Miyagi 983-8551 (JP)**
- **YOSHIDA Manabu**
**Tsukuba-shi**
**Ibaraki 305-8565 (JP)**
- **YAMASHITA Takashi**
**Tokyo 162-8601 (JP)**

(74) Representative: **Webster, Jeremy Mark et al**
**Mewburn Ellis LLP**
**33 Gutter Lane**
**London**
**EC2V 8AS (GB)**

(54) **NON-COMBUSTIBLE FILM, DISPERSION LIQUID FOR NON-COMBUSTIBLE FILMS, METHOD FOR PRODUCING NON-COMBUSTIBLE FILM, SOLAR CELL BACK SHEET, FLEXIBLE BOARD, AND SOLAR CELL**

(57) The present invention aims to provide a non-combustible film having excellent flexibility, excellent moisture resistance, and high mechanical strength. The present invention also aims to provide a dispersion liquid for non-combustible films which is used in production of the non-combustible film, a method for producing a non-combustible film using the above dispersion, and a solar cell back sheet and a flexible board each of which is formed from the above non-combustible film. The present invention further aims to provide a solar cell including the solar cell back sheet. The non-combustible film of the present invention includes a water-insoluble inorganic compound and a heat-resistant synthetic resin, the water-insoluble inorganic compound constituting from 30% by weight to 90% by weight inclusive of the total weight of the non-combustible film, the film exhibiting a flammability of VTM-0 in the UL-94 VTM test.

EP 2 719 716 A1

## Description

### TECHNICAL FIELD

The present invention relates to a non-combustible film having excellent flexibility, excellent moisture resistance, and high mechanical strength. The present invention also relates to a dispersion liquid for non-combustible films which is used in production of the above non-combustible film, a method for producing a non-combustible film using the above dispersion, and a solar cell back sheet and a flexible board each of which is formed from the above non-combustible film. The present invention further relates to a solar cell including the solar cell back sheet.

### BACKGROUND ART

Recent miniaturization, thinning, and sophistication in the fields of machinery and electronic devices have led to a desire for a flexible, sophisticated film having excellent properties including heat resistance, chemical resistance, hydrolysis resistance, flame retardancy, non-combustibility, dimensional stability, and vapor barrier property. Especially for building materials, vehicle materials, and electric product materials, non-combustible materials have been desired to guarantee the safety and reliability of products.

Up until now, non-combustible films such as films containing a fluororesin or glass sheets have been developed. Fluororesins, however, are expensive, have a high coefficient of thermal expansion giving poor dimensional stability, and have a maximum service temperature as low as around 200°C inhibiting use under high temperatures. Glass sheets are inexpensive and have very good properties including heat resistance and moisture resistance, but have insufficient flexibility.

Generally used plastic films such as polyimide films are flexible, but have poor moisture resistance and heat resistance. Many attempts have therefore been made in recent years to produce more sophisticated films by mixing a synthetic resin with an inorganic compound. Addition of an inorganic compound in an increasing amount surely achieves better moisture resistance and heat resistance, but instead decreases the flexibility and mechanical strength. It has been thus difficult to produce a film having excellent non-combustibility, excellent flexibility, excellent moisture resistance, and high mechanical strength.

There are reports on films produced from a polyimide resin and inorganic compounds such as clay, but inorganic compounds are usually not uniformly mixed with a polyimide resin and are separated out of the mixture, providing a non-uniform film. Patent Literatures 1 to 4 each teach a film obtained from a uniform dispersion liquid of polyimide and inorganic compounds, using an additive of clay of which the interlayer ion is replaced with an organic ion. Since the clay contains an organic material, the resulting film has a defect of low heat resistance which causes the film to be burnt when exposed to flame.

Patent Literatures 5 and 6 each teach a film produced using a dilute dispersion liquid for non-combustible films which contains nonvolatile components in a proportion of 5% by weight or less of the total weight of the dispersion liquid. These films, however, have an inorganic compound content in a proportion of 8% by weight or less of the total nonvolatile components, and thus contain organic components accounting for the majority of the dispersion liquid. The films therefore have inferior non-combustibility.

Patent Literature 7 teaches a film having an inorganic compound content in a proportion of 90% by weight or more of the total nonvolatile components. The film of Patent Literature 7 is produced using a dilute dispersion liquid with nonvolatile components in a proportion of 1% by weight or less of the total weight of the dispersion liquid. The dispersion liquid, however, provides low productivity of films because removal of a large amount of the dispersion medium is required. Also, the resulting film has a defect of low handleability because it is easily broken and shows low mechanical strength.

Patent Literature 8 teaches a technique of improving the durability of a polyurethane adhesive in a solar cell back sheet being a laminate obtained by attaching at least two substrates with the polyurethane adhesive, which is determined by an accelerated test at 85°C and 85%RH. Still, use of an adhesive causes the resulting back sheet to have insufficient durability even if the durability of the adhesive is improved by the technique of Patent Literature 8.

### CITATION LIST

#### Patent Literature

Patent Literature 1: JP 2003-340919 A
Patent Literature 2: JP 2002-322292 A

Patent Literature 3: JP 2003-342471 A
Patent Literature 4: JP 3744634 B
Patent Literature 5: JP 2010-533213 T
Patent Literature 6: JP 2010-533362 T
Patent Literature 7: JP 2006-77237 A
Patent Literature 8: JP 2008-4691 A

## SUMMARY OF INVENTION

### Technical Problem

The present invention aims to provide a non-combustible film having excellent flexibility, excellent moisture resistance, and high mechanical strength. The present invention also aims to provide a dispersion liquid for non-combustible films which is used in production of the above non-combustible film, a method for producing a non-combustible film using the above dispersion, and a solar cell back sheet and a flexible board each of which is formed from the above non-combustible film. The present invention further aims to provide a solar cell including the solar cell back sheet.

### Solution to Problem

One aspect of the present invention is a non-combustible film comprising a water-insoluble inorganic compound and a heat-resistant synthetic resin, the water-insoluble inorganic compound constituting from 30% by weight to 90% by weight inclusive of the total weight of the non-combustible film, the film exhibiting a flammability of VTM-0 in the UL-94 VTM test.

The present invention is described in detail below.

The non-combustible film of the present invention contains a water-insoluble inorganic compound.

The term "water-insoluble" as used herein means that the material in question has a solubility of less than 1.0 g in 100 ml of 20°C water.

The water-insoluble inorganic compound is preferably at least one selected from the group consisting of silica compounds, silica-alumina compounds, aluminum compounds, calcium compounds, and nitrides. The water-insoluble inorganic compound is more preferably a silica compound or a silica-alumina compound, and is still more preferably a phyllosilicate mineral in terms of decreasing the water vapor permeability.

Examples of the phyllosilicate mineral include natural or synthetic micas, talc, kaolin, pyrophyllite, sericite, vermiculite, smectite, bentonite, stevensite, montmorillonite, beidellite, saponite, hectorite, and nontronite. Particularly, talc, kaolin, pyrophyllite, a non-swelling mica, and sericite are preferred in terms of production of a uniform non-combustible film at a low cost, and at least one selected from the group consisting of talc, kaolin, pyrophyllite, and non-swelling micas is more preferred.

Examples of the silica-alumina compounds include zeolite and mullite.

Examples of the silica compounds include wollastonite and glass beads.

Examples of the aluminum compounds include spinel, aluminum hydroxide, aluminum oxide (alumina), and aluminum borate. The aluminum compound is preferably used in combination with the above phyllosilicate mineral in terms of decreasing the coefficient of linear expansion of the resulting non-combustible film, and more preferably in combination with talc. Still more preferably, the aluminum compound is alumina and used in combination with talc. Examples of the calcium compounds include calcium carbonate.

Examples of the nitrides include silicon nitride and boron nitride.

These water-insoluble inorganic compounds may be used alone or in combination.

When the water-insoluble inorganic compound to be used is selected, the particle size is preferably taken into consideration because the properties of the resulting non-combustible film are different depending also on the average particle size of the water-insoluble inorganic compound.

The average particle size of the water-insoluble inorganic compound is preferably from a lower limit of 0.1 μm to an upper limit of 50 μm. An average particle size of the water-insoluble inorganic compound of smaller than 0.1 μm may provide low mechanical strength to the resulting non-combustible film. An average particle size of the water-insoluble inorganic compound of greater than 50 μm may result in poor surface flatness of the resulting non-combustible film. The average particle size of the water-insoluble inorganic compound is more preferably from a lower limit of 0.2 μm to an upper limit of 20 μm, and still more preferably from a lower limit of 0.5 μm to an upper limit of 15 μm.

The average particle size of the water-insoluble inorganic compound can be determined by measuring the particle size distribution using a laser diffraction particle size analyzer.

Here, if, for example, a material having a low relative dielectric constant, such as talc or zeolite, is used, a non-combustible film having a low dielectric constant can be produced.

The relative dielectric constant of the non-combustible film of the present invention may vary depending on the use. In the case that the non-combustible film is used for a flexible printed board, for example, the relative dielectric constant is preferably 4 or less, more preferably 3 or less, and still more preferably 2.5 or less.

The lower limit for the water-insoluble inorganic compound content is 30% by weight of the total weight of the non-combustible film. A water-insoluble inorganic compound content of less than 30% by weight increases not only the water vapor permeability and coefficient of linear expansion of the resulting film, but also the combustibility of the film. In terms of decreasing the heat shrinkage rate of the resulting film, the lower limit for the water-insoluble inorganic compound content is preferably 35% by weight, more preferably 40% by weight, still more preferably 50% by weight, and particularly preferably 60% by weight. The upper limit for the water-insoluble inorganic compound content is 90% by weight of the total weight of the non-combustible film. A water-insoluble inorganic compound content of more than 90% by weight gives poor mechanical strength to the resulting film. The upper limit for the water-insoluble inorganic compound content is preferably 85% by weight, more preferably 80% by weight, and still more preferably 70% by weight.

The non-combustible film of the present invention contains a heat-resistant synthetic resin.

The heat-resistant synthetic resin is a super engineering plastic such as a polyimide resin, a polyamide-imide resin, a fluororesin, a polyphenylene sulfide resin, a polysulfone resin, a polyarylate resin, a polyether sulfone resin, a polyether imide resin, a polyether ether ketone resin, a polybenzoxazole resin, or a polybenzimidazole resin. Particularly, at least one selected from the group consisting of polyimide resins, polyamide-imide resins, and polybenzoxazole resins is suitable because they have excellent film-forming property, excellent heat resistance, and excellent mechanical strength.

In terms of the heat resistance, the heat-resistant synthetic resin preferably does not contain a saturated cyclic hydrocarbon such as a cyclohexane ring. To achieve especially favorable heat resistance of the resulting non-combustible film, the heat-resistant synthetic resin preferably has an aromatic ring, and is still more preferably at least one selected from the group consisting of aromatic polyimide resins, aromatic polyamide-imide resins, and aromatic polybenzoxazole resins.

For a decrease in the water vapor permeability, a polybenzoxazole resin is preferably used for the heat-resistant synthetic resin.

The polyimide resin is a compound having a repeating unit represented by the following formula (1). The polyamide-imide resin is a compound having a repeating unit represented by the following formula (2). The polybenzoxazole resin is a compound having a repeating unit represented by the following formula (3).

[Chem. 1]

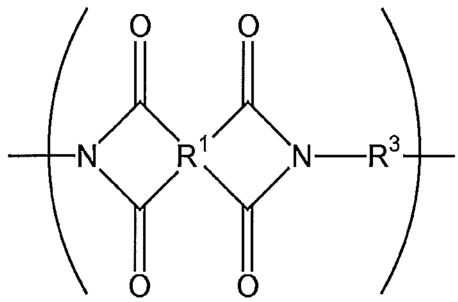

(1)

In formula (1), $R^1$ is a tetravalent organic group having one or two benzene rings. $R^1$ is preferably any of the moieties represented by the following formula (4). The polyimide resin may have one of the moieties represented by formula (4) as $R^1$, or may be a copolymer having at least two of these moieties as $R^1$s.

[Chem. 2]

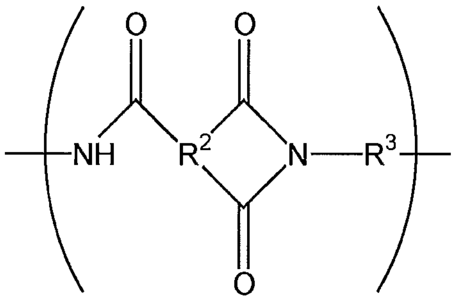

(2)

In formula (2), $R^2$ is a trivalent organic group having one or two benzene rings. $R^2$ is preferably any of the moieties represented by the following formula (5). The polyamide-imide resin may have one of the moieties represented by formula (5) as $R^2$, or may be a copolymer having at least two of these moieties as $R^2$s.

[Chem. 3]

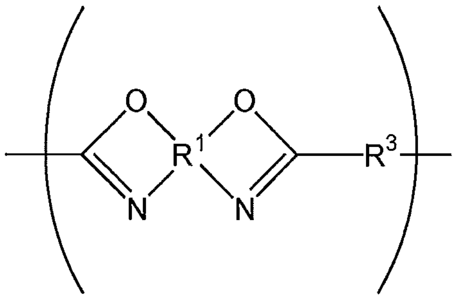

(3)

In formula (3), $R^1$ is a tetravalent organic group having one or two benzene rings. $R^1$ is preferably any of the moieties represented by the following formula (4). The polybenzoxazole resin may have one of the moieties represented by formula (4) as $R^1$, or may be a copolymer having at least two of these moieties as $R^1$s.

[Chem. 4]

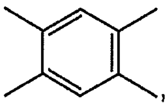,
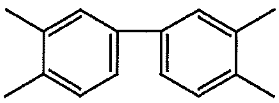,
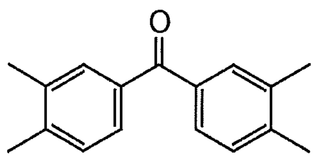,

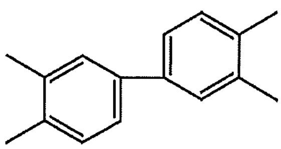,
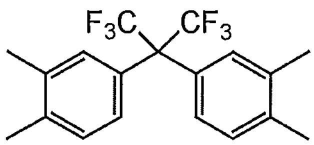,
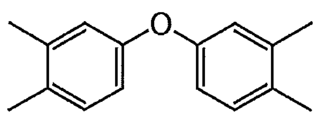

(4)

[Chem. 5]

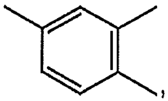,
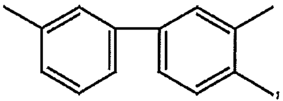,
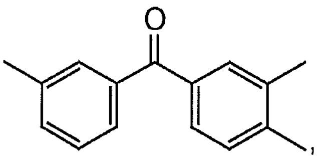,
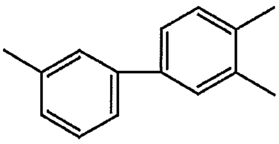,
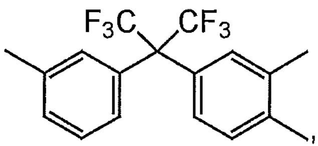,
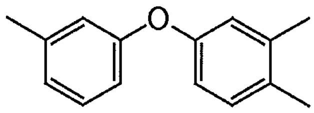

(5)

In formula (1), formula (2), and formula (3), $R^3$ is a divalent organic group having one or two benzene rings. $R^3$ is preferably any of the moieties represented by the following formula (6). The polyimide resin, the polyamide-imide resin, and the polybenzoxazole resin may each have one of the moieties represented by formula (6) as $R^3$, or may each be a copolymer having at least two of these moieties as $R^3$s.

[Chem. 6]

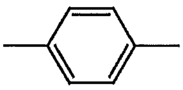,
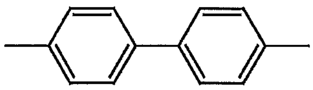,
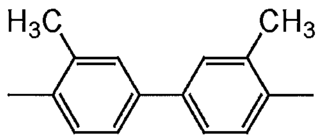,
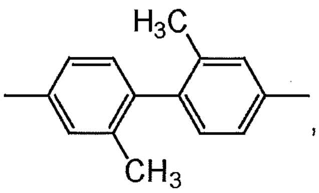,
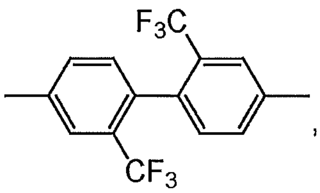,
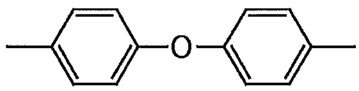,
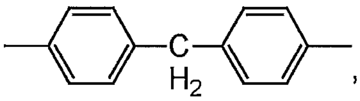,
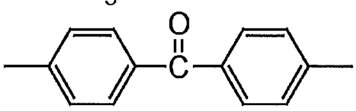

(6)

For inexpensiveness and excellent mechanical strength of the resulting non-combustible film, $R^1$, $R^2$, and $R^3$ are preferably the respective moieties represented by the following formula (7). The polyimide resin and the polybenzoxazole resin may each have one combination of the moieties represented by formula (7) for $R^1$ and $R^3$, or may each be a copolymer having at least two combinations of the moieties for $R^1$ and $R^3$. The polyamide-imide resin may have one combination of the moieties represented by formula (7) for $R^2$ and $R^3$, or may be a copolymer having at least two combinations of the moieties for $R^2$ and $R^3$.

The heat-resistant synthetic resin may be a copolymer of at least two of the polyimide resin, the polybenzoxazole resin, and the polyamide imide resin.

[Chem. 7]

R[1]: 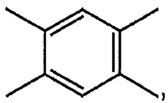, 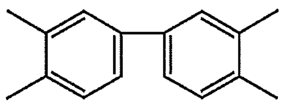

R[2]: 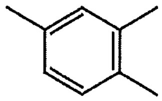, 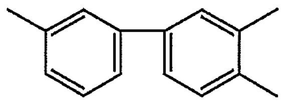

R[3]: 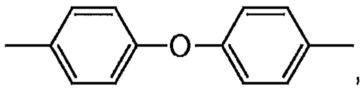, 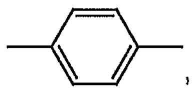, 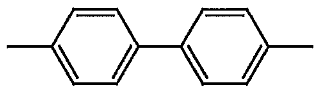

(7)

The non-combustible film of the present invention may contain a coupling agent such as a silane coupling agent or a titanate coupling agent to increase the mechanical strength.

Examples of the silane coupling agent include amino silane coupling agents, ureido silane coupling agents, vinyl silane coupling agents, methacrylic silane coupling agents, epoxy silane coupling agents, mercapto silane coupling agents, and isocyanate silane coupling agents.

Examples of the titanate coupling agent include titanate coupling agents having a C1-C60 alkylate group, titanate coupling agents having an alkyl phosphite group, titanate coupling agents having an alkyl phosphate group, and titanate coupling agents having an alkyl pyrophosphate group.

The coupling agent may be mixed with water-insoluble inorganic compound(s) in advance, or may be mixed into the later-described dispersion liquid for non-combustible films.

The amount of the coupling agent used is preferably from a lower limit of 0.1% by weight to an upper limit of 3.0% by weight of the total weight of the water-insoluble inorganic compound(s). An amount of the coupling agent used of less than 0.1% by weight may not achieve a sufficient effect of using a coupling agent. An amount of the coupling agent used of more than 3.0% by weight may not lead to an effect commensurate with the increased amount of use. The amount of the coupling agent is more preferably from a lower limit of 0.5% by weight to an upper limit of 2.0% by weight.

The thickness of the non-combustible film of the present invention is preferably 10 μm or more. The non-combustible film with a thickness of smaller than 10 μm may have low mechanical strength, which may be difficult to handle. The thickness of the non-combustible film is more preferably 20 μm or more.

The thickness of the non-combustible film of the present invention is preferably 250 μm or less. The non-combustible film with a thickness of greater than 250 μm may be stiff, showing lower flex strength. The thickness of the non-combustible film is more preferably 200 μm or less.

The non-combustible film of the present invention exhibits a flammability of VTM-0 in the UL-94 thin material vertical burning test (VTM test). The VTM test is performed by rolling a film specimen into a cylinder, mounting the rolled specimen vertically to the clamp, bringing 20-mm size flame into contact with the specimen for 3 seconds twice, and determining the flammability of the specimen as shown in Table 1 based on the burning behaviors.

The non-combustible film of the present invention to be subjected to the UL-94 VTM test preferably has a thickness of 100 μm or less, and more preferably 80 μm or less.

[Table 1]

| | | Flammability | | |
|---|---|---|---|---|
| | | VTM-0 | VTM-1 | VTM-2 |
| Determination criteria | Burning time of each specimen | ≤ 10 sec | ≤ 30 sec | ≤ 30 sec |
| | Total burning time of 5 specimens | ≤ 50 sec | ≤ 250 sec | ≤ 250 sec |
| | Burning + glowing time of each specimen | ≤ 30 sec | ≤ 60 sec | ≤ 60 sec |
| | Burning to clamp | Not occurred | Not occurred | Not occurred |
| | Cotton ignition by droppings | Not occurred | Not occurred | Occurred |

The non-combustible film of the present invention preferably has a flammability of V-0 in the UL-94 vertical burning test (V test). The V test is performed by mounting a specimen vertically to the clamp, bringing 20-mm size flame into contact with the specimen for 10 seconds twice, and determining the flammability of the specimen as shown in Table 2 based on the burning behaviors.

[Table 2]

| | | Flammability | | |
|---|---|---|---|---|
| | | V-0 | V-1 | V-2 |
| Determination criteria | Burning time of each specimen | ≤ 10 sec | ≤ 30 sec | ≤ 30 sec |
| | Total burning time of 5 specimens | ≤ 50 sec | ≤ 250 sec | ≤ 250 sec |
| | Burning + glowing time of each specimen | ≤ 30 sec | ≤ 60 sec | ≤ 60 sec |
| | Burning to clamp | Not occurred | Not occurred | Not occurred |
| | Cotton ignition by droppings | Not occurred | Not occurred | Occurred |

The non-combustible film of the present invention preferably has a flammability of 5V-A or 5V-B in the UL-94 125-mm vertical burning test (5V test). In the 5V test, a strip specimen is vertically mounted to the clamp, 125-mm size flame is brought into contact with the specimen for 5 seconds five times, and the flammability of the specimen is determined based on the burning behaviors. Also in the test, a flat plate specimen is horizontally held, 125-mm size flame is brought into contact with the specimen from the bottom for 5 seconds five times, and the flammability of the specimen as shown in Table 3 is determined based on the burning behaviors.

[Table 3]

| | | Flammability | |
|---|---|---|---|
| | | 5V-A | 5V-B |
| Determination criteria | Burning + glowing time of each strip specimen after the 5th flame contact | ≤ 30 sec | ≤ 60 sec |
| | Cotton ignition by droppings from strip specimen | Not occurred | Not occurred |
| | Presence of hole after flame contact (flat plate specimen) | No | Yes |

The non-combustible film of the present invention preferably has non-combustibility defined in a rolling stock material combustion test based on "Ministerial Ordinance to Provide the Technical Standard on Railway", the Ministerial Ordinance No. 151 promulgated by the Ministry of Land, Infrastructure, Transport and Tourism.

The non-combustible film of the present invention preferably has, in a heat release test using a cone calorimeter in accordance with ISO 5660-1, a total heat release from the area of the sample over 20 minutes from the start of heating of 8 $MJ/m^2$ or less, a maximum heat release rate from the area of the sample over 20 minutes from the start of heating of 300 $kw/m^2$ or less, and a time from the start of the test to the ignition of 60 seconds or more.

The non-combustible film of the present invention preferably has a heat shrinkage rate of 0.6% or less when burnt at 350°C for 30 minutes. The non-combustible film having a heat shrinkage rate of higher than 0.6% may not be easily used as, for example, an electric material. The film more preferably has a heat shrinkage rate of 0.3% or less, still more preferably 0.2% or less, and particularly preferably 0.1% or less.

The non-combustible film of the present invention preferably has a coefficient of linear expansion at 50°C to 250°C of $5.0 \times 10^{-5}$/°C or less. The non-combustible film having a coefficient of linear expansion of higher than $5.0 \times 10^{-5}$/°C may not be easily attached to a material such as metal. The film more preferably has a coefficient of linear expansion of $4.0 \times 10^{-5}$/°C or less, and still more preferably $3.0 \times 10^{-5}$/°C or less.

The non-combustible film of the present invention preferably has a tear strength of 25 N/mm or more. The film with a tear strength of lower than 25 N/mm may be easily torn, which is difficult to handle. The film more preferably has a tear strength of 30 N/mm or more, and still more preferably 40 N/mm or more.

The tear strength herein refers to a value obtained by the measuring method in accordance with JIS K7128-1.

The non-combustible film of the present invention preferably has a tensile strength of 25 $N/mm^2$ or more. The film with a tensile strength of lower than 25 N/mm may be easily torn, which is difficult to handle. The film more preferably has a tensile strength of 30 $N/mm^2$ or more, and still more preferably 40 $N/mm^2$ or more.

The tensile strength herein refers to a value obtained by the measuring method in accordance with JIS K7127-1, and is measured using a tensile strength tester with a grip distance of 80 mm and a pulling rate of 20 mm/min.

The non-combustible film of the present invention preferably cracks in a bend test using a cylindrical mandrel in accordance with JIS-K5600-5-1 (1999) when the diameter of the mandrel is 10 mm or less. The film which cracks when the diameter of the mandrel is greater than 10 mm may have poor flexibility. The film preferably cracks when the diameter of the mandrel is 8 mm or less, more preferably 5 mm or less, and particularly preferably 4 mm or less.

The non-combustible film of the present invention preferably has a dielectric breakdown voltage of 20 kV/mm or more. The film with a dielectric breakdown voltage of lower than 20 kV/mm may not be easily used as, for example, an electric material. The film more preferably has a dielectric breakdown voltage of 25 kV/mm or more, and still more preferably 30 kV/mm or more.

The non-combustible film of the present invention preferably has a partial discharge voltage of 700 V or more in the partial discharge test in accordance with IEC61730-2:2004, item 11.1. The film with a partial discharge voltage of 700 V or less may be locally degraded because of electrolysis concentration, and thus is not easily used as an electric material. The film preferably has a partial discharge voltage of 1000 V or more, more preferably 1500 V or more, and still more preferably 2000 V or more.

The non-combustible film of the present invention preferably has a water vapor permeability of 20 $g/m^2 \cdot day$ or less at 40°C and 90%RH. The film with a water vapor permeability of more than 20 $g/m^2 \cdot day$ at 40°C and 90%RH may not be easily used as, for example, an electric material. The film more preferably has a water vapor permeability of 10

$g/m^2 \cdot day$ or less, and still more preferably 5 $g/m^2 \cdot day$ or less, at 40°C and 90%RH.

The non-combustible film of the present invention preferably has a coefficient of water absorption of 2.0% or less by weight after being immersed in 40°C water for 24 hours. The film with a coefficient of water absorption of higher than 2.0% by weight may not be easily used as, for example, an electric material. The film has a coefficient of water absorption of 1.0% by weight or less.

The non-combustible film of the present invention preferably has a coefficient of moisture absorption of 2.0% by weight or less after being left to stand for 24 hours at 40°C and 90%RH. The film with a coefficient of moisture absorption of higher than 2.0% by weight may not be easily used as, for example, an electric material. The film more preferably has a coefficient of moisture absorption of 1.0% by weight or less.

The non-combustible film of the present invention preferably does not undergo a change such as discoloration or peeling on the surface or the cross-section even after storage for at least 500 hours in a weather resistance test under an over-humid condition of 85°C and 85%RH. The film, if undergoing a change within 500 hours in the weather resistance test, may not be used for outdoor products such as solar cells. The time it takes for the film to undergo a change such as discoloration or peeling on the surface or the cross-section in the weather resistance test is preferably 1000 hours or more, more preferably 2000 hours or more, and still more preferably 3000 hours or more.

The non-combustible film of the present invention can be produced by a method including: a step 1 of preparing a dispersion liquid for non-combustible films; a step 2 of spreading the prepared dispersion liquid on a substrate and allowing the substrate to stand; and a step 3 of removing the dispersion medium from the dispersion liquid spread on the substrate to form a film, and removing the film from the substrate. Such a method for producing a non-combustible film is another aspect of the present invention.

The present inventors have found that a non-combustible film (non-combustible film of the present invention) having excellent flexibility, excellent moisture resistance, and high mechanical strength, which could not have been easily obtained by the conventional arts, can be produced using a dispersion liquid that has the nonvolatile component content and the water-insoluble inorganic compound content in the nonvolatile component within the respective specific ranges.

The method for producing a non-combustible film according to the present invention shows high productivity because it employs inexpensive water-insoluble inorganic compound(s) and can reduce the amount of the dispersion medium to be volatilized from the dispersion liquid.

The step 1 of the method for producing a non-combustible film according to the present invention is a step of preparing a dispersion liquid for non-combustible films which contains a dispersion medium; and nonvolatile components of a water-insoluble inorganic compound and at least one of a heat-resistant synthetic resin and a precursor of the heat-resistant synthetic resin. Here, the water-insoluble inorganic compound constitutes from 30% by weight to 90% by weight inclusive of the total weight of the nonvolatile components, and the nonvolatile components constitute more than 18% by weight and 65% by weight or less of the total weight of the dispersion liquid for non-combustible films. Such a dispersion liquid for non-combustible films is yet another aspect of the present invention.

The above "nonvolatile component" herein refers to a component without a boiling point or with a boiling point of at least 300°C under ordinary pressure. The water-insoluble inorganic compound(s) and the heat-resistant synthetic resin in the dispersion liquid for non-combustible films according to the present invention are the same as those in the non-combustible film of the present invention, and thus the explanation thereof is omitted.

Examples of the heat-resistant synthetic resin include the same resins as those mentioned for the above-described non-combustible film of the present invention.

Examples of the precursor of the heat-resistant synthetic resin include polyamic acids. Conversion of a polyamic acid into an imide or oxazole provides a polyimide resin, a polyamide-imide resin, or a polybenzoxazole resin. Examples of the method for converting a polyamic acid into an imide or oxazole include converting the polyamic acid into an imide or oxazole through thermal ring-closure of the polyamic acid, converting the polyamic acid into an imide through chemical ring-closure of the polyamic acid, or converting the polyamic acid into an imide through chemical ring-closure of the polyamic acid, and heating the imidized polyamic acid to form oxazole.

Examples of the method of converting a polyamic acid into an imide or oxazole through thermal ring-closure include, but not particularly limited to, dispersing the polyamic acid into a dispersion medium, and heating the dispersion at 120°C to 400°C for 0.5 to 10 hours.

In the case of adding a precursor of a heat-resistant synthetic resin into the dispersion liquid for non-combustible films according to the present invention, the amount of the precursor to be added is preferably from a lower limit of 2% by weight to an upper limit of 45% by weight. An amount of the precursor to be added of less than 2% by weight may give low mechanical strength to the resulting non-combustible film. An amount of the precursor to be added of more than 45% by weight may give low heat resistance to the resulting non-combustible film. The amount of the precursor to be added is more preferably from a lower limit of 5% by weight to an upper limit of 30% by weight.

The dispersion medium may be, for example, a hydrocarbon solvent (e.g., n-pentane, n-hexane, n-octane, n-decane), an alcohol solvent (e.g., methanol, ethanol, 1-propanol, 2-propanol, 1-butanol, 2-butanol, isobutanol, tert-butanol, 1-pentanol, 2-pentanol, 1-hexanol, 2-hexanol, ethylene glycol, propylene glycol), a ketone solvent (e.g., acetone, methyl ethyl ketone, diethyl ketone, methyl isobutyl ketone, cyclohexane), an amide solvent (e.g., N,N-dimethylformamide, N,N-dimethylacetamide, N,N-dimethylpropionamide, N-methyl-2-pyrrolidone), an ether solvent (e.g., diethylether, methyl-tert butyl ether, dioxane, tetrahydrofuran, cyclopentyl methyl ether), a benzene solvent (e.g., benzene, chlorobenzene, o-dichlorobenzene, m-dichlorobenzene, p-dichlorobenzene, toluene, o-xylene, p-xylene, ethylbenzene, phenol, p-chlorophenol, o-chlorophenol, o-cresol), or a sulfur solvent (e.g., dimethyl sulfoxide, dimethyl sulfone, sulfolane). The dispersion medium may be water used in an amount that does not allow the additives to be deposited. For high solubility of the heat-resistant synthetic resin, at least one selected from the group consisting of N-methyl-2-pyrrolidone, N,N-dimethylformamide, N,N-dimethylacetamide, dimethyl sulfoxide, tetrahydrofuran, and sulfolane. These solvent media may be used alone or in combination.

The lower limit for the water-insoluble inorganic compound content in the dispersion liquid for non-combustible films according to the present invention is 30% by weight of the total weight of the nonvolatile components. A water-insoluble inorganic compound content of less than 30% by weight increases not only the water vapor permeability and coefficient of linear expansion but also the combustibility of the resulting film. The lower limit for the water-insoluble inorganic compound content is preferably 35% by weight, more preferably 40% by weight, still more preferably 50% by weight, and particularly preferably 60% by weight.

The upper limit for the water-insoluble inorganic compound content in the dispersion liquid for non-combustible films according to the present invention is 90% by weight of the total weight of the nonvolatile components. A water-insoluble inorganic compound content of more than 90% by weight gives poor mechanical strength to the resulting film. The upper limit for the water-insoluble inorganic compound content is preferably 85% by weight, more preferably 80% by weight, and still more preferably 70% by weight.

The nonvolatile component content in the dispersion liquid for non-combustible films according to the present invention is more than 18% by weight and 65% by weight or less. A nonvolatile component content of 18% by weight or less makes the dispersion liquid for non-combustible films non-uniform to produce a non-uniform film. A nonvolatile component content of more than 65% by weight excessively increases the viscosity of the dispersion liquid for non-combustible films such that a film cannot be produced. The nonvolatile component content is preferably more than 20% by weight and 55% by weight or less, and more preferably more than 25% by weight and 45% by weight or less.

The nonvolatile component content in the dispersion liquid for non-combustible films according to the present invention can be determined from the weight of a solid residue resulting from removal of the solvent through vacuum evaporation using a device such as a thermogravimetric analyzer (TG), a thermogravimetric/differential thermal analyzer (TG-DTA), or an evaporator.

Examples of the method of spreading the dispersion liquid on a substrate in the step 2 include a method of applying the dispersion liquid into the shape of a film using, for example, a doctor blade or a bar coater.

The step 2 is performed preferably with the dispersion liquid spread to a thickness of 50 μm or more on the substrate. A thickness of the dispersion liquid of less than 50 μm may result in a thin non-combustible film with low mechanical strength. The lower limit for the thickness of the dispersion liquid is more preferably 100 μm, and still more preferably 150 μm.

The substrate on which the dispersion liquid is to be spread is preferably made of glass, polyethylene terephthalate, polyimide, polyethylene, or polypropylene, in terms of the compatibility, wettability, and release property after drying between the substrate and the dispersion liquid.

Examples of the method for removing the dispersion medium from the dispersion liquid for non-combustible films spread on the substrate in the step 3 include various solid liquid separation methods such as centrifugation, filtration, vacuum drying, freeze vacuum drying, heat evaporation, and combinations of these methods. In the case of employing, for example, heat evaporation in which the dispersion liquid is poured into a vessel, a film is obtained by drying the dispersion liquid applied to the substrate in a horizontal position at 20°C to 150°C, preferably at 30°C to 120°C, for about 0.5 to 24 hours, preferably 2 to 12 hours, using forced air oven.

In the case of adding a precursor of a heat-resistant synthetic resin to the dispersion liquid for non-combustible films, a non-combustible film can be obtained by further heating the obtained film using, for example, an electric furnace. More specifically, in the case of adding a polyamic acid as a precursor of a heat-resistant synthetic resin, a non-combustible film can be obtained by heating the above film at 120°C to 400°C for 0.5 to 10 hours.

The non-combustible film of the present invention may be a laminated product obtained by uniting at least two films

The films constituting the laminated product may be the same as or different from each other.

In each of the films constituting the laminated product, the water-insoluble inorganic compound content is not particularly limited. That is, a laminated product can be used as the non-combustible film of the present invention if the water-insoluble inorganic compound constitutes from 30% by weight to 90% by weight inclusive of the total weight of the laminated product, and the laminated product exhibits a flammability of VTM-0 in the UL-94 VTM test.

Examples of the laminated product include a laminated product with improved flexibility obtained by laminating

a polyimide film free from water-insoluble inorganic compounds on each surface of a polyimide film that contains water-insoluble inorganic compound(s).

Examples of the method for producing the laminated product include a method of performing the processes up to the removal of a dispersion medium in the steps 1 to 3 for a predetermined number of times to a film, serving as the substrate, obtained by removing a dispersion medium from the dispersion liquid for non-combustible films in the step 3 of the above method for producing a non-combustible film; and heating the resulting product in an electric furnace as needed.

The non-combustible film of the present invention has excellent flexibility, excellent moisture resistance, excellent electrical insulation, and high mechanical strength, and can therefore be used as a solar cell back sheet. The solar cell back sheet is yet another aspect of the present invention.

A solar cell including the solar cell back sheet of the present invention is yet another aspect of the present invention. Since the solar cell back sheet of the present invention has excellent flexibility, excellent moisture resistance, excellent electrical insulation, and high mechanical strength, a solar cell including the back sheet has excellent durability and excellent weather resistance. Also, since a solar cell back sheet typically has a multilayer structure including multiple resin layers, long-term use of the back sheet deteriorates, for example, the adhesive layers bonding the resin layers. The non-combustible film of the present invention, however, is a single layer or a laminate of two or more layers, and thus can suppress such aging deterioration of a solar cell when used as a solar cell back sheet.

Fig. 1 is a schematic cross-sectional view illustrating an example of the solar cell of the present invention.

As illustrated in Fig. 1, a solar cell 1 of the present invention includes solar cell elements 2 for converting light energy into electric energy by the photovoltaic effect. The solar cell elements 2 are enclosed by a sealing material 3. The solar cell 1 of the present invention has a light-transmissive substrate 4 on the surface on the sunlight receiving side, and has the solar cell back sheet 5 of the present invention on the surface opposite the light-transmissive substrate 4.

The solar cell elements 2 may be formed from any material if the material can convert light energy into electric energy by photovoltaic effect. For example, monocrystalline silicon, polycrystalline silicon, amorphous silicon, and compound semiconductors (group III-V, group II-VI, and other compounds) can be used. Preferred among these is polycrystalline silicon.

Examples of the sealing material 3 include ethylene-vinyl acetate copolymers, ethylene-aliphatic unsaturated carboxylic acid copolymers, ethylene-aliphatic carboxylic acid ester copolymers, and saponified products of these copolymers.

Since the light-transmissive substrate 4 constitutes the outermost layer on the sunlight receiving side of the solar cell 1, the light-transmissive substrate 4 preferably has excellent properties including weather resistance, water repellence, contamination resistance, and mechanical strength in addition to transparency.

Examples of the light-transmissive substrate 4 include substrates made of a resin (e.g., polyester resin, fluororesin, acrylic resin, ethylene-vinyl acetate copolymer) and glass substrates. Glass substrates are preferred because they have excellent weather resistance and excellent impact resistance, and can be produced at a low cost. Particularly in terms of the excellent weather resistance, fluororesin is also suitable.

Examples of the method for producing the solar cell 1 of the present invention include, but not particularly limited to, vacuum lamination of the light-transmissive substrate 4, the sealing material enclosing the solar cell elements 2, and the solar cell back sheet 5 of the present invention in the stated order.

The non-combustible film of the present invention can also be used for a flexible board because it has high flexibility, high mechanical strength, and a low coefficient of linear expansion. Examples of the flexible board include a flexible printed circuit board. The flexible board is yet another aspect of the present invention.

Advantageous Effects of Invention

The present invention provides a non-combustible film having excellent flexibility, excellent moisture resistance, and high mechanical strength. The present invention also provides a dispersion liquid for non-combustible films which is used in production of the above non-combustible film, a method for producing a non-combustible film using the above dispersion, and a solar cell back sheet and a flexible board each of which is formed from the above non-combustible film. The present invention further provides a solar cell including the solar cell back sheet.

BRIEF DESCRIPTION OF DRAWINGS

[Fig. 1] Fig. 1 is a schematic cross-sectional view illustrating an example of the solar cell of the present invention.
[Fig. 2] Fig. 2(a) illustrates a front surface of a solar cell module including a non-combustible film of Example 14; and Fig. 2(b) illustrates a back surface thereof.

DESCRIPTION OF EMBODIMENTS

The present invention is described below in more detail based on examples which, however, are not intended to limit the scope of the present invention.

(Example 1)

(Preparation of dispersion liquid for non-combustible films)

Talc ("Talc MS-K" from Nippon Talc Co., Ltd., 6.0 g) and a 18.6% by weight solution of a polyamic acid in N-methyl-2-pyrrolidone ("U-Varnish A" from Ube Industries, Ltd., 20.0 g; 3.7 g of the polyamic acid, 16.3 g of N-methyl-2-pyrrolidone) were put into a plastic airtight container. These materials were stirred by a planetary centrifugal mixer ("ARE-310" from THINKY CORPORATION) in the mixing mode (2000 rpm) for 10 minutes and in the deaeration mode (2200 rpm) for 10 minutes. Thereby, a uniform dispersion liquid for non-combustible films with a talc content of 61.9% by weight of the total nonvolatile components and a nonvolatile component content of 37.3% by weight of the total weight of the dispersion liquid was produced.

The polyamic acid contained in "U-varnish A" is an aromatic polyamic acid having a repeating structural unit represented by the following formula (8).

[Chem. 8]

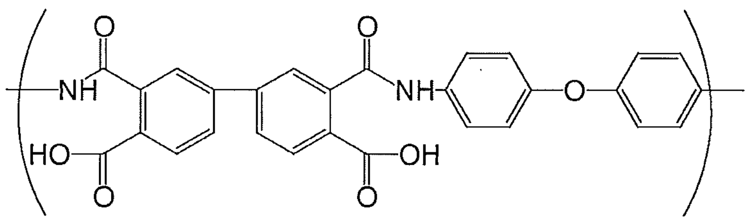

(8)

(Production of film)

The obtained dispersion liquid for non-combustible films was applied by a doctor blade to a polypropylene sheet having a smooth, rectangular bottom face, to a thickness of 400 μm. The dispersion liquid was dried in a 50°C forced air oven for 10 hours with the polypropylene sheet held in a horizontal position, so that a film was formed on the polypropylene sheet. The film was peeled off the polypropylene sheet, and heated at 120°C for 30 minutes, at 150°C for 5 minutes, at 200°C for 5 minutes, and at 350°C for 30 minutes. Thereby, an 80-μm-thick non-combustible film made of talc and a polyimide resin with a talc content of 61.9% by weight of the total weight of the film was produced.

(Example 2)

A uniform dispersion liquid for non-combustible films with a talc content of 42.2% by weight of the total nonvolatile components and a nonvolatile component content of 28.2% by weight of the total weight of the dispersion liquid was produced in the same manner as in Example 1, except that the amount of talc used was changed to 2.7 g.

From the obtained dispersion liquid for non-combustible films, an 80-μm-thick non-combustible film with a talc content of 42.2% by weight of the total weight of the film was produced in the same manner as in Example 1.

(Example 3)

(Preparation of dispersion liquid 1 for non-combustible films)

Talc ("Talc MS-K" from Nippon Talc Co., Ltd., 3.0 g) and a 18.6% by weight solution of a polyamic acid in N-methyl-2-pyrrolidone ("U-Varnish A" from Ube Industries, Ltd., 37.6 g; 7.0 g of the polyamic acid, 30.6 g of N-methyl-2-pyrrolidone) were put into a plastic airtight container. These materials were stirred by a planetary centrifugal mixer ("ARE-310" from THINKY CORPORATION) in the mixing mode (2000 rpm) for 10 minutes and in the deaeration mode (2200 rpm) for 10 minutes. Thereby, a uniform dispersion liquid 1 for non-combustible films with a talc content of 30.0% by weight of the total nonvolatile components and a nonvolatile component content of 24.6% by weight of the total weight of the dispersion liquid was produced.

(Preparation of dispersion liquid 2 for non-combustible films)

Talc ("Talc MS-K" from Nippon Talc Co., Ltd., 6.0 g) and a 18.6% by weight solution of a polyamic acid in N-methyl-2-pyrrolidone ("U-Varnish A" from Ube Industries, Ltd., 21.5 g; 4.0 g of the polyamic acid, 17.5 g of N-methyl-2-pyrrolidone) were put into a plastic airtight container. These materials were stirred by a planetary centrifugal mixer ("ARE-310" from THINKY CORPORATION) in the mixing mode (2000 rpm) for 10 minutes and in the deaeration mode (2200 rpm) for 10 minutes. Thereby, a uniform dispersion liquid 2 for non-combustible films with a talc content of 60.0% by weight of the total nonvolatile components and a nonvolatile component content of 36.4% by weight of the total weight of the dispersion liquid was produced.

(Production of film)

The obtained dispersion liquid 1 for non-combustible films was applied by a doctor blade to a polyethylene terephthalate sheet having a smooth, rectangular bottom face, to a thickness of 100 μm. The dispersion liquid 1 was dried in a 120°C forced air oven for 1 hour with the polyethylene terephthalate sheet held in a horizontal position. The sheet was taken out of the oven. The dispersion liquid 2 for non-combustible films was applied by a doctor blade to the surface of the sheet on which the dispersion liquid 1 for non-combustible films was applied, to a thickness of 400 μm. The dispersion liquid 2 was dried in a 140°C forced air oven for 2 hours with the sheet held in a horizontal position. The sheet was taken out of the oven. The dispersion liquid 1 for non-combustible films was applied by a doctor blade to the surface of the sheet on which the dispersion liquid 2 for non-combustible films was applied, to a thickness of 100 μm. The dispersion liquid 1 was dried in a 150°C forced air oven for 1 hour with the sheet held in a horizontal position, so that a film was formed on the polyethylene terephthalate sheet. The film was peeled off the polyethylene terephthalate sheet, and heated at 200°C for 5 minutes, and at 350°C for 30 minutes. Thereby, a 120-μm-thick non-combustible film made of talc and a polyimide resin with a talc content of 50.0% by weight of the total weight of the film was produced. The produced non-combustible film was a laminate of three layers, namely a first layer of 20 μm in thickness with a talc content of 30.0% by weight in the weight of the layer, a second layer of 80 μm in thickness with a talc content of 60.0% by weight in the weight of the layer, and a third layer of 20 μm in thickness with a talc content of 30.0% by weight in the weight of the layer.

(Example 4)

(Synthesis of polyamic acid varnish)

A 2-L reaction vessel with a stirrer and a thermometer was charged with 4,4-diaminodiphenyl ether (70.1 g, 0.35 mol), p-phenylene diamine (37.8 g, 0.35 mol), and N,N-dimethylacetamide (1273.9 g). These materials were dissolved at 50°C. To the reaction vessel was added pyromellitic dianhydride (152.7 g, 0.70 mol) over 2 hours with the temperature maintained at 45°C to 50°C. The mixture was stirred at the same temperatures for 30 minutes. A 4.2% by weight solution of phthalic anhydride in N,N-dimethylacetamide (7.4 g, 0.002 mol) was added to the mixture to terminate the reaction, whereby polyamic acid varnish (1541.9 g) with a concentration of 16.9% and a viscosity of 5.8 Pa·s was produced.

(Preparation of dispersion liquid for non-combustible films)

Talc ("Talc MS-K" from Nippon Talc Co., Ltd., 7.0 g) and the synthesized polyamic acid varnish (17.8 g; 3.0 g of polyamic acid, 14.8 g of N,N-dimethylacetamide) were put into a plastic airtight container. These materials were stirred by a planetary centrifugal mixer ("ARE-310" from THINKY CORPORATION) in the mixing mode (2000 rpm) for 10 minutes and in the deaeration mode (2200 rpm) for 10 minutes. Thereby, a uniform dispersion liquid for non-combustible films with a talc content of 70.0% by weight of the total nonvolatile components and a nonvolatile component content of 40.3% by weight of the total weight of the dispersion liquid was produced.

(Production of film)

The obtained dispersion liquid for non-combustible films was applied by a doctor blade to a polyethylene terephthalate sheet having a smooth, rectangular bottom face, to a thickness of 500 μm. The dispersion liquid was dried in an 80°C forced air oven for 2 hours with the polyethylene terephthalate sheet held in a horizontal position, so that a film was formed on the polyethylene terephthalate sheet. The film was peeled off the polyethylene terephthalate sheet, and heated at 120°C for 30 minutes, at 150°C for 5 minutes, at 200°C for 5 minutes, and at 350°C for 1 hour. Thereby, a 110-μm-thick non-combustible film made of talc and a polyimide resin with a talc content of 70.0% by weight of the

total weight of the film was produced.

(Example 5)

(Synthesis of polyamic acid varnish)

A 2-L reaction vessel with a stirrer and a thermometer was charged with 4,4-diaminodiphenyl ether (140.1 g, 0.70 mol) and N,N-dimethylacetamide (1603.0 g). These materials were dissolved at 50°C. To the reaction vessel were added pyromellitic dianhydride (74.5 g, 0.34 mol) and 3,3',4,4'-biphenyl tetracarboxylic dianhydride (99.8 g, 0.34 mol) over 2 hours with the temperature maintained at 45°C to 50°C. The mixture was stirred at the same temperatures for 60 minutes. A 4.2% by weight solution of phthalic anhydride in N,N-dimethylacetamide (7.4 g, 0.002 mol) was added to the mixture to terminate the reaction, whereby polyamic acid varnish (1924.8 g) with a concentration of 16.3% and a viscosity of 5.8 Pa·s was produced.

(Preparation of dispersion liquid for non-combustible films)

Talc ("Talc MS-K" from Nippon Talc Co., Ltd., 6.1 g) and the synthesized polyamic acid varnish (25.0 g; 4.1 g of the polyamic acid, 20.9 g of N,N-dimethylacetamide) were put into a plastic airtight container. These materials were stirred by a planetary centrifugal mixer ("ARE-310" from THINKY CORPORATION) in the mixing mode (2000 rpm) for 10 minutes and in the deaeration mode (2200 rpm) for 10 minutes. Thereby, a uniform dispersion liquid for non-combustible films with a talc content of 59.8% by weight of the total nonvolatile components and a nonvolatile component content of 32.8% by weight of the total weight of the dispersion liquid was produced.

(Production of film)

The obtained dispersion liquid for non-combustible films was applied by a doctor blade to a polyethylene terephthalate sheet having a smooth, rectangular bottom face, to a thickness of 700 μm. The dispersion liquid was dried in an 80°C forced air oven for 2 hours with the polyethylene terephthalate sheet held in a horizontal position, so that a film was formed on the polyethylene terephthalate sheet. The film was peeled off the polyethylene terephthalate sheet, and heated at 120°C for 30 minutes, at 150°C for 5 minutes, at 200°C for 5 minutes, and at 350°C for 1 hour. Thereby, a 90-μm-thick non-combustible film made of talc and a polyimide resin with a talc content of 59.8% by weight of the total weight of the film was produced.

(Example 6)

Talc ("Talc MS-K" from Nippon Talc Co., Ltd., 2.8 g), alumina ("A-42-2" from Showa Denko K.K., 2.8 g), a 18.6% by weight solution of a polyamic acid in N-methyl-2-pyrrolidone ("U-Varnish A" from Ube Industries, Ltd., 20.0 g; 3.7 g of the polyamic acid, 16.3 g of N-methyl-2-pyrrolidone), and N-methyl-2-pyrrolidone (4.2 g) were put into a plastic airtight container. These materials were mixed and stirred in the same manner as in Example 1. Thereby, a uniform dispersion liquid for non-combustible films with a water-insoluble inorganic compound content (talc + alumina) of 60.2% by weight of the total nonvolatile components and a nonvolatile component content of 31.2% by weight of the total weight of the dispersion liquid was produced.

A 100-μm-thick non-combustible film made of talc, alumina, and a polyimide resin, with a water-insoluble inorganic compound content (talc + alumina) of 60.2% by weight of the total weight of the film, was produced in the same manner as in Example 1, except that the obtained dispersion liquid for non-combustible films was applied by a doctor blade to a polyethylene terephthalate sheet having a smooth, rectangular bottom face, to a thickness of 700 μm.

(Example 7)

Talc ("Talc MS-K" from Nippon Talc Co., Ltd., 1.6 g) and a 18.6% by weight solution of a polyamic acid in N-methyl-2-pyrrolidone ("U-Varnish A" from Ube Industries, Ltd., 20.0 g; 3.7 g of the polyamic acid, 16.3 g of N-methyl-2-pyrrolidone) were put into a plastic airtight container. These materials were mixed and stirred in the same manner as in Example 1. Thereby, a uniform dispersion liquid for non-combustible films with a talc content of 30.2% by weight of the total nonvolatile components and a nonvolatile component content of 24.5% by weight of the total weight of the dispersion liquid was produced.

A 90-μm-thick non-combustible film made of talc and a polyimide resin, with a talc content of 30.2% by weight of the total weight of the film, was produced in the same manner as in Example 1, except that the obtained dispersion liquid for non-combustible films was applied by a doctor blade to a polyethylene terephthalate sheet having a smooth,

rectangular bottom face, to a thickness of 700 μm.

(Example 8)

Talc ("Talc MS-K" from Nippon Talc Co., Ltd., 14.9 g), a 18.6% by weight solution of a polyamic acid in N-methyl-2-pyrrolidone ("U-Varnish A" from Ube Industries, Ltd., 20.0 g; 3.7 g of the polyamic acid, 16.3 g of N-methyl-2-pyrrolidone), and N-methyl-2-pyrrolidone (11.3 g) were put into a plastic airtight container. These materials were mixed and stirred in the same manner as in Example 1. Thereby, a uniform dispersion liquid for non-combustible films with a talc content of 80.1% by weight of the total nonvolatile components and a nonvolatile component content of 40.3% by weight of the total weight of the dispersion liquid was produced.

A 90-μm-thick non-combustible film made of talc and a polyimide resin, with a talc content of 80.1% by weight of the total weight of the film, was produced in the same manner as in Example 1, except that the obtained dispersion liquid for non-combustible films was applied by a doctor blade to a polyethylene terephthalate sheet having a smooth, rectangular bottom face, to a thickness of 700 μm.

(Example 9)

Kaolin ("XP01-6100" from Imerys, 5.6 g), a 18.6% by weight solution of a polyamic acid in N-methyl-2-pyrrolidone ("U-Varnish A" from Ube Industries, Ltd., 20.0 g; 3.7 g of the polyamic acid, 16.3 g of N-methyl-2-pyrrolidone), and N-methyl-2-pyrrolidone (2.8 g) were put into a plastic airtight container. These materials were mixed and stirred in the same manner as in Example 1. Thereby, a uniform dispersion liquid for non-combustible films with a water-insoluble inorganic compound content of 60.2% by weight of the total nonvolatile components and a nonvolatile component content of 32.7% by weight of the total weight of the dispersion liquid was produced.

A 110-μm-thick non-combustible film made of kaolin and a polyimide resin, with a water-insoluble inorganic compound content of 60.2% by weight of the total weight of the film, was produced in the same manner as in Example 1, except that the obtained dispersion liquid for non-combustible films was applied by a doctor blade to a polyethylene terephthalate sheet having a smooth, rectangular bottom face, to a thickness of 700 μm.

(Example 10)

A non-swelling mica ("SJ-010" from YAMAGUCHI MICA CO., LTD., 5.6 g), a 18.6% by weight solution of a polyamic acid in N-methyl-2-pyrrolidone ("U-Varnish A" from Ube Industries, Ltd., 20.0 g; 3.7 g of the polyamic acid, 16.3 g of N-methyl-2-pyrrolidone), and N-methyl-2-pyrrolidone (3.2 g) were put into a plastic airtight container. These materials were mixed and stirred in the same manner as in Example 1. Thereby, a uniform dispersion liquid for non-combustible films with a water-insoluble inorganic compound content of 60.2% by weight of the total nonvolatile components and a nonvolatile component content of 32.3% by weight of the total weight of the dispersion liquid was produced.

A 100-μm-thick non-combustible film made of a non-swelling mica and a polyimide resin, with a water-insoluble inorganic compound content of 60.2% by weight of the total weight of the film, was produced in the same manner as in Example 1, except that the obtained dispersion liquid for non-combustible films was applied by a doctor blade to a polyethylene terephthalate sheet having a smooth, rectangular bottom face, to a thickness of 700 μm.

(Example 11)

Alumina ("A-42-2" from Showa Denko K.K., 5.6 g), a 18.6% by weight solution of a polyamic acid in N-methyl-2-pyrrolidone ("U-Varnish A" from Ube Industries, Ltd., 20.0 g; 3.7 g of the polyamic acid, 16.3 g of N-methyl-2-pyrrolidone), and N-methyl-2-pyrrolidone (1.2 g) were put into a plastic airtight container. These materials were mixed and stirred in the same manner as in Example 1. Thereby, a uniform dispersion liquid for non-combustible films with a water-insoluble inorganic compound content of 60.2% by weight of the total nonvolatile components and a nonvolatile component content of 34.7% by weight of the total weight of the dispersion liquid was produced.

A 110-μm-thick non-combustible film made of alumina and a polyimide resin, with a water-insoluble inorganic compound content of 60.2% by weight of the total weight of film, was produced in the same manner as in Example 1, except that the obtained dispersion liquid for non-combustible films was applied by a doctor blade to a polyethylene terephthalate sheet having a smooth, rectangular bottom face, to a thickness of 700 μm.

(Example 12)

(Synthesis of polyamic acid varnish)

A 200-mL reaction vessel with a stirrer and a thermometer was charged with 3,3'-dihydroxybenzidine (6.49 g, 0.030 mol) and N,N-dimethylacetamide (126.9 g). These materials were dissolved at room temperature. The solution was cooled to 0°C, and mixed with pyromellitic dianhydride (1.96 g, 0.0090 mol) and biphenyl tetracarboxylic dianhydride (6.18 g, 0.021 mol) at 0°C to 10°C over 2 hours. The resulting mixture was stirred for 30 minutes. The mixture was then stirred at room temperature for 24 hours, whereby polyamic acid varnish (141.5 g) having a concentration of 10.2% was produced.

(Preparation of dispersion liquid for non-combustible films)

Talc ("Talc MS-K" from Nippon Talc Co., Ltd., 9.2 g), the synthesized polyamic acid varnish (60.0 g; 6.1 g of the polyamic acid, 53.9 g of N,N-dimethylacetamide), and N,N-dimethylacetamide (15.0 g) were put into a plastic airtight container. These materials were stirred by a planetary centrifugal mixer ("ARE-310" from THINKY CORPORATION) in the mixing mode (2000 rpm) for 10 minutes and in the deaeration mode (2200 rpm) for 10 minutes. Thereby, a uniform dispersion liquid for non-combustible films with a talc content of 60.1% by weight of the total nonvolatile components and a nonvolatile component content of 18.2% by weight of the total weight of the dispersion liquid was produced.

(Production of film)

The obtained dispersion liquid for non-combustible films was applied by a doctor blade to a polyethylene terephthalate sheet having a smooth, rectangular bottom face, to a thickness of 1000 μm. The dispersion liquid was dried in an 80°C forced air oven for 2 hours with the polyethylene terephthalate sheet held in a horizontal position, so that a film was formed on the polyethylene terephthalate sheet. The film was peeled off the polyethylene terephthalate sheet, and heated at 120°C for 30 minutes, at 150°C for 5 minutes, at 200°C for 5 minutes, and at 350°C for 1 hour. Thereby, a 70-μm-thick non-combustible film made of talc and a polybenzoxazole resin with a talc content of 60.1% by weight of the total weight of the film was produced.

(Example 13)

(Synthesis of polyamic acid varnish)

A 200-mL reaction vessel with a stirrer and a thermometer was charged with 3,3'-dihydroxybenzidine (3.24 g, 0.015 mol), 4,4-diaminodiphenyl ether (3.00 g, 0.015 mol), and N,N-dimethylacetamide (65.8 g). These materials were dissolved at room temperature. The solution was cooled to 0°C, and mixed with pyromellitic dianhydride (1.96 g, 0.0090 mol) and biphenyl tetracarboxylic dianhydride (6.18 g, 0.021 mol) at 0°C to 10°C over 2 hours. The resulting mixture was stirred for 30 minutes. The mixture was then stirred at room temperature for 24 hours, whereby polyamic acid varnish (80.2 g) having a concentration of 17.9% was produced.

(Preparation of dispersion liquid for non-combustible films)

Talc ("Talc MS-K" from Nippon Talc Co., Ltd., 10.7 g), the synthesized polyamic acid varnish (40.0 g; 7.2 g of the polyamic acid, 32.8 g of N,N-dimethylacetamide), and N,N-dimethylacetamide (18.0 g) were put into a plastic airtight container. These materials were stirred by a planetary centrifugal mixer ("ARE-310" from THINKY CORPORATION) in the mixing mode (2000 rpm) for 10 minutes and in the deaeration mode (2200 rpm) for 10 minutes. Thereby, a uniform dispersion liquid for non-combustible films with a talc content of 59.8% by weight of the total nonvolatile components and a nonvolatile component content of 26.1% by weight of the total weight of the dispersion liquid was produced.

(Production of film)

The obtained dispersion liquid for non-combustible films was applied by a doctor blade to a polyethylene terephthalate sheet having a smooth, rectangular bottom face, to a thickness of 600 μm. The dispersion liquid was dried in an 80°C forced air oven for 2 hours with the polyethylene terephthalate sheet held in a horizontal position, so that a film was formed on the polyethylene terephthalate sheet. The film was peeled off the polyethylene terephthalate sheet, and heated at 120°C for 30 minutes, at 150°C for 5 minutes, at 200°C for 5 minutes, and at 350°C for 1 hour. Thereby, a 60-μm-thick non-combustible film made of talc and a copolymer resin of a polybenzoxazole resin and a polyimide

resin with a talc content of 59.8% by weight of the total weight of the film was produced.

(Comparative Example 1)

Talc ("Talc MS-K" from Nippon Talc Co., Ltd., 6.0 g), a 18.6% by weight solution of a polyamic acid in N-methyl-2-pyrrolidone ("U-Varnish A" from Ube Industries, Ltd., 20.0 g), and N-methyl-2-pyrrolidone (28.0 g) were put into a plastic airtight container, so that the talc content was 61.7% by weight of the total nonvolatile components and the nonvolatile component content was 18.0% by weight of the total weight of the dispersion liquid. The container was vigorously shaken in a shaker, and left to stand. After a few minutes, talc precipitated, which means that a uniform dispersion was not produced.

The dispersion was also subjected to the film formation process in the same manner as in Example 1, but talc precipitated to give a non-uniform film.

(Comparative Example 2)

Talc ("Talc MS-K" from Nippon Talc Co., Ltd., 18.5 g), a 18.6% by weight solution of a polyamic acid in N-methyl-2-pyrrolidone solution ("U-Varnish A" from Ube Industries, Ltd., 10.0 g; 1.9 g of the polyamic acid, 8.1 g of N-methyl-2-pyrrolidone), and N-methyl-2-pyrrolidone (14.0 g) were put into a plastic airtight container. These materials were stirred by a planetary centrifugal mixer ("ARE-310" from THINKY CORPORATION) in the mixing mode (2000 rpm) for 10 minutes and in the deaeration mode (2200 rpm) for 10 minutes. Thereby, a uniform dispersion liquid for non-combustible films with a talc content of 90.7% by weight of the total nonvolatile components and a nonvolatile component content of 48.0% by weight of the total weight of the dispersion liquid was produced.

The obtained dispersion liquid for non-combustible films was applied by a doctor blade to a polypropylene sheet having a smooth, rectangular bottom face, to a thickness of 250 μm. The dispersion liquid was dried in a 50°C forced air oven for 10 hours with the polypropylene sheet held in a horizontal position, so that a film was formed on the polypropylene sheet. The film was peeled off the polypropylene sheet, and heated at 120°C for 30 minutes, at 150°C for 5 minutes, at 200°C for 5 minutes, and at 350°C for 30 minutes. Thereby, a 70-μm-thick non-combustible film made of talc and a polyimide resin with a talc content of 90.7% by weight of the total weight of the film of was produced.

(Comparative Example 3)

A 18.6% by weight solution of a polyamic acid in N-methyl-2-pyrrolidone ("U-Varnish A" from Ube Industries, Ltd., 50.0 g; 9.3 g of the polyamic acid, 40.7 g of N-methyl-2-pyrrolidone) was put into a plastic airtight container. The materials were stirred by a planetary centrifugal mixer ("ARE-310" from THINKY CORPORATION) in the deaeration mode (2200 rpm) for 10 minutes. The obtained dispersion liquid for non-combustible films was applied by a doctor blade to a polypropylene sheet having a smooth, rectangular bottom face, to a thickness of 750 μm. The dispersion liquid was dried in a 50°C forced air oven for 10 hours with the polypropylene sheet held in a horizontal position, so that a film was formed on the polypropylene sheet. The film was peeled off the polypropylene sheet, and heated at 120°C for 30 minutes, at 150°C for 5 minutes, at 200°C for 5 minutes, and at 350°C for 30 minutes. Thereby, an 80-μm-thick polyimide resin film free from water-insoluble inorganic compounds was produced.

(Comparative Example 4)

Talc ("Talc MS-K" from Nippon Talc Co., Ltd., 6.0 g) and a 18.0% by weight solution of N-methoxymethyl nylon in an alcohol ("Toresin FS-350" from Nagase ChemteX Corporation, 20.0 g; 3.6 g of N-methoxymethyl nylon, 16.4 g of the alcohol) were put into a plastic airtight container. These materials were stirred by a planetary centrifugal mixer ("ARE-310" from THINKY CORPORATION) in the mixing mode (2000 rpm) for 10 minutes and in the deaeration mode (2200 rpm) for 10 minutes. Thereby, a dispersion liquid for non-combustible films with a talc content of 62.5% by weight of the total nonvolatile components and a nonvolatile component of 36.9% by weight of the total weight of the dispersion liquid was produced.

The obtained dispersion liquid for non-combustible films was applied by a doctor blade to a polypropylene sheet having a smooth, rectangular bottom face, to a thickness of 500 μm. The dispersion liquid was dried in a 50°C forced air oven for 10 hours with the polypropylene sheet held in a horizontal position, so that a film was formed on the polypropylene sheet. The film was peeled off the polypropylene sheet, and heated at 120°C for 30 minutes and at 150°C for 60 minutes. Thereby, a 120-μm-thick white film made of talc and a nylon resin with a talc content of 62.5% by weight of the total weight of the film was produced.

(Comparative Example 5)

A 18.6% by weight solution of a polyamic acid in N-methyl-2-pyrrolidone ("U-Varnish A" from Ube Industries, Ltd., 20.0 g; 3.7 g of the polyamic acid, 16.3 g of N-methyl-2-pyrrolidone) was put into a plastic airtight container. The solution was placed in a 60°C oven so that the solvent was evaporated to give a total amount of 10.0 g, whereby a 37.2% by weight solution of a polyamic acid in N-methyl-2-pyrrolidone (3.7 g of the polyamic acid, 6.3 g of N-methyl-2-pyrrolidone) was produced. To the mixture, talc ("Talc MS-K" from Nippon Talc Co., Ltd., 8.6 g) was added. These materials were stirred by a planetary centrifugal mixer ("ARE-310" from THINKY CORPORATION) in the mixing mode (2000 rpm) for 10 minutes and in the deaeration mode (2200 rpm) for 10 minutes. Thereby, a uniform dispersion liquid for non-combustible films with a water-insoluble inorganic compound content of 69.9% by weight of the total nonvolatile components and a nonvolatile component content of 66.1% by weight of the total weight of the dispersion liquid was produced.
The produced dispersion liquid for non-combustible films could not be applied to a substrate because it had almost no fluidity, failing to give a film.

(Comparative Example 6)

(Synthesis of polyamic acid varnish)

A 500-mL reaction vessel with a stirrer and a thermometer was charged with 3,3',4,4'-biphenyl tetracarboxylic dianhydride (29.4 g, 0.10 mol) and N,N-dimethylacetamide (80.8 g). These materials were dissolved at room temperature. The solution was cooled to 0°C, and mixed with a mixture of 4,4-diaminodicyclohexylmethane (21.0 g, 0.10 mol) and N,N-dimethylacetamide (37.0 g) at 0°C to 25°C over 2 hours. The resulting mixture was stirred at room temperature for 1 week. A 4.2% by weight solution of phthalic anhydride in N,N-dimethylacetamide (0.7 g, 0.0002 mol) was added to the mixture to terminate the reaction, whereby polyamic acid varnish (168.9 g) with a concentration of 29.8% and a viscosity of 10 Pa·s was produced.

(Preparation of dispersion liquid for non-combustible films)

Talc ("Talc MS-K" from Nippon Talc Co., Ltd., 2.0 g) and the synthesized polyamic acid varnish (20.0 g; 6.0 g of polyamic acid and 14.0 g of N,N-dimethylacetamide) were put into a plastic airtight container. These materials were stirred by a planetary centrifugal mixer ("ARE-310" from THINKY CORPORATION) in the mixing mode (2000 rpm) for 10 minutes and in the deaeration mode (2200 rpm) for 10 minutes. Thereby, a uniform dispersion liquid for non-combustible films with a talc content of 25.0% by weight of the total nonvolatile components and a nonvolatile component content of 36.4% by weight of the total weight of the dispersion liquid was produced.

(Production of film)

The obtained dispersion liquid for non-combustible films was applied by a doctor blade to a polyethylene terephthalate sheet having a smooth, rectangular bottom face, to a thickness of 500 μm. The dispersion liquid was dried in an 80°C forced air oven for 2 hours with the polyethylene terephthalate sheet held in a horizontal position, so that a film was formed on the polyethylene terephthalate sheet. The film was peeled off the polyethylene terephthalate sheet, and heated at 120°C for 30 minutes, at 150°C for 5 minutes, and at 200°C for 1 hour. Thereby, an 80-μm-thick film formed from talc and a polyimide resin with a talc content of 25.0% by weight of the total weight of the film was produced.

<Evaluation>

The following evaluations were performed on the non-combustible films produced in Examples 1 to 13. The results are shown in Tables 4 to 6.
In Comparative Example 1 and Comparative Example 5 in which a film could not be formed, the following evaluations were not performed. The flexibility evaluation was performed on the film produced in Comparative Example 6. The heat shrinkage rate and coefficient of linear expansion evaluations were performed on the film produced in Comparative Example 3. The flammability evaluation by the VTM test and the flammability evaluation by the V test were performed on the films produced in Comparative Example 4 and Comparative Example 6.

(Flammability determined by VTM test)

The UL-94 thin material vertical burning test (VTM test) was performed on the produced non-combustible films.
For each criterion shown in Table 1, 5 specimens (length: about 200 mm, width; about 50 mm) of each film

were used. The size of flame was 20 mm.

The flame contact time was 3 seconds, and the afterflame time was measured after each flame contact. Simultaneously with the flame extinction, the specimen was brought into contact with flame for 3 seconds for the second time, and the afterflame time was measured in the same manner as for the first measurement. Also, whether or not the cotton placed below the specimen was ignited by burning cinders fallen from the specimen was observed. The benchmark was at a position 125 mm from the bottom of the specimen, and the marking cotton was placed 300 mm below the bottom of the specimen.

In the VTM test, VTM-0 shows the highest level of flame retardancy, followed by the lower flame retardancy levels of VTM-1 and VTM-2. If a specimen is not evaluated as having flammability corresponding to any of the levels from VTM-0 to VTM-2, the specimen was evaluated as "failed".

The films produced in Comparative Example 4 and Comparative Example 6 failed the VTM test performed in the same manner.

(Flammability determined by V test)

The UL-94 vertical burning test (V test) was performed on the produced non-combustible films.

For each criterion shown in Table 2, 5 specimens (length: 127 mm, width: 13 mm) of each film were used. The size of flame was 20 mm.

The flame contact time was 10 seconds, and the afterflame time was measured after each flame contact.

Simultaneously with the flame extinction, the specimen was brought into contact with flame for 10 seconds for the second time, and the afterflame time was measured in the same manner as for the first measurement. Also, whether or not the cotton placed below the specimen was ignited by burning cinders fallen from the specimen was observed.

The flammability of each specimen was determined in accordance with the UL-94 standard based on the results including the first and second combustion times and the occurrence of cotton ignition. In the V test, V-0 shows the highest level of flame retardancy, followed by the lower flame retardancy levels of V-1 and V-2. If a specimen is not evaluated as having flammability corresponding to any of the levels from V-0 to V-2, the specimen was evaluated as "failed".

The films produced in Comparative Example 4 and Comparative Example 6 failed the V test performed in the same manner.

(Flammability determined by 5V test)

The UL-94 125-mm vertical burning test (5V test) was performed on the produced non-combustible films.

For each criterion shown in Table 3, 5 specimens (length: 127 mm, width: 13 mm) of each film were used. The size of flame was 125 mm.

The flame contact time was 5 seconds, and the afterflame time was measured after each flame contact.

Simultaneously with the flame extinction, the specimen was brought into contact with flame for 5 seconds for the second time, and the afterflame time was measured in the same manner as for the first measurement. The process was repeated 5 times. Also, whether or not the cotton placed below the specimen was ignited by burning cinders fallen from the specimen was observed.

The flammability of each tested specimen was evaluated in accordance with the UL-94 5V test based on the results including the first to fifth combustion times and the occurrence of cotton ignition. The specimens which passed this test were further subjected to the plate burning test.

In the plate burning test, a plate specimen (length: 150 mm, width: 150 mm) was used. The size of flame was 125 mm.

The flame contact time was 5 seconds, and simultaneously with the flame extinction, the specimen was brought into contact with flame for 5 seconds for the second time. This process was repeated 5 times. The existence of a hole in the plate specimen was checked after the flame contacts. A plate with no hole was evaluated as 5V-A, and a plate with a hole was evaluated as 5 V-B.

(Non-combustibility evaluation)

The test was performed by the following process in accordance with "Ministerial Ordinance to Provide the Technical Standard on Railway", the Ministerial Ordinance No. 151 promulgated by the Ministry of Land, Infrastructure, Transport and Tourism. That is, a specimen (length: 257 mm, width: 182 mm) obtained from the produced non-combustible film was held at an inclination of 45°, with the short sides thereof positioned at the top and the bottom. A fuel container (made of iron, thickness: 0.8 mm, diameter: 17.5 mm, height: 7.1 mm) was placed on a platform such that the center of the container came to a position vertically below the center of the bottom face of the specimen by 25.4 mm. Pure ethyl alcohol (0.5 mL) was poured into the container, ignited, and left to stand until the fuel burned out. The flammability during

burning and the flammability after burning were evaluated separately. During burning, ignition of the specimen, flaming, smoke, and force of fire were observed. After burning, afterflame, flameless burning, charring, and deformation were observed.

A specimen without ignition and with a small amount of smoke was evaluated as being "highly flame retardant" if its discoloration did not reach the edge of the specimen after the burning of ethyl alcohol, or evaluated as being "non-combustible" if its discoloration was within a range of 100 mm.

(Cone calorimeter test)

(Evaluation of total heat release, maximum heat release rate, and ignition start time)

The obtained non-combustible film was subjected to measurements of the total heat release ($MJ/m^2$) after 20 minutes from the start of heating, the maximum heat release rate ($kW/m^2$) after 20 minutes from the start of heating, and the time (seconds) from the start of heating to ignition, using a cone calorimeter in accordance with ISO5660-1 ("Cone calorimeter III" from Toyo Seiki Seisakusho, Ltd.).

(Heat shrinkage rate)

A specimen with a width of 5 mm and a length of 10 mm was produced from the obtained non-combustible film. The specimen was put in a TMA apparatus ("TMA-60" from Shimadzu Corporation), and was heated from room temperature at 10°C/min, held at 350°C for 30 minutes, and cooled at 10°C /min, in the tension measurement mode with a load of 1.0 g. After the cooling, the heat shrinkage rate of the specimen was measured from the change in the shrinkage rate before and after the heating to 60°C.

The polyimide resin film obtained in Comparative Example 3 showed a heat shrinkage rate of 1.6% in the measurement performed in the above manner.

(Coefficient of linear expansion)

A specimen with a width of 5 mm and a length of 10 mm was produced from the obtained non-combustible film. The specimen was put in a TMA apparatus ("TMA-60" from Shimadzu Corporation), and subjected to measurement of the coefficient of linear expansion at 50°C to 250°C in the tension measurement mode with a load of 1.0 g and heating at 10°C/min.

The polyimide resin film obtained in Comparative Example 3 showed a coefficient of linear expansion of $3.5 \times 10^{-5} K^{-1}$ in the measurement performed in the above manner.

(Flex resistance)

The obtained non-combustible film was subjected to a flex resistance test (by the cylindrical mandrel method) in accordance with JIS-K5600-5-1. The test was performed on each specimen using 1- to 5-mm-diameter mandrels from a larger-diameter mandrel to a smaller-diameter mandrel to determine the mandrel diameter at which cracking or splitting of the film occurred. A film which did not crack with a 1-mm mandrel is determined as ≤ 1 mm.

The non-combustible film produced in Comparative Example 2 showed a result of 25 mm in the flex resistance test performed in the above manner.

(Tear strength)

The tear resistance of the obtained non-combustible film was determined by the method in accordance with JIS K7128-1. The non-combustible film was cut into a sample size of 150 mm × 50 mm. The sample was cut to a length of 75 mm in the length direction from the center of the non-combustible film, so that a slit was formed. Here, the tear propagation resistance was measured using a table-top type precision universal tester ("AGS-J" from Shimadzu Corporation) at a tear rate of 200 mm/min. The tear propagation resistance was determined by calculating the average tear strength of a part of 50 mm in length which is the part other than 20 mm from the tearing start position and 5 mm before the tearing end position. The number of specimens for measurement was 5 in one example, and the average of the values a1 to a5 of the respective specimens was calculated. The calculated average was taken as the tear strength of the example.

(Tensile strength)

A 40-mm-width specimen was produced from the obtained non-combustible film. The breaking strength of the specimen was measured using a table-top type precision universal tester ("AGS-J" from Shimadzu Corporation) with a grip distance of 40 mm and a rate of pulling of 200 mm/min.

(Dielectric breakdown voltage)

The dielectric breakdown voltage was measured by the method in accordance with JIS C2110. The positive electrode was a 10-cm square aluminum foil electrode with a thickness of 100 μm, and the negative electrode was a 25-mmφ brass electrode. The non-combustible film was sandwiched between the electrodes, and was charged with voltage increasing at a rate of 100 V/sec by a DC high-voltage power source (from KASUGA DENKI, INC.). The film was regarded as being dielectrically broken down when the film carried a current of 10 mA or more. The voltage when the dielectric breakdown occurred was divided by the thickness of the film at the measurement point, and the resulting value was regarded as the dielectric breakdown strength. The measurement was performed at 5 points, and the median of the values was taken as the dielectric breakdown voltage.

(Water vapor permeability)

By the gas chromatography in accordance with JIS K 7126, method A (differential pressure method), the water vapor permeability of the non-combustible film at 40°C and 90%RH was measured using a gas/water vapor permeability testing system (from GTR Tec Corporation) which is capable of measuring the gas or water vapor permeability and moisture permeability.

(Coefficient of water absorption)

A sample (about 0.2 g) was taken from the non-combustible film, and the mass of the sample was weighed accurately to a unit of 0.1 mg (the mass measured here is referred to as $W_0$). The sample was allowed to stand in a 40°C water bath for 24 hours. The mass was weighed, which is referred to as $W_1$. Using these values, the coefficient of water absorption was determined from the following formula.

$$\text{Coefficient of water absorption (\% by weight)} = ((W_1-W_0)/W_0) \times 100$$

(Coefficient of moisture absorption)

A sample (about 0.2 g) was taken from the non-combustible film, and the mass of the sample was weighed accurately to a unit of 0.1 mg (the mass measured here is referred to as $W_0$). The sample was allowed to stand under atmosphere at 40°C and 90%RH for 24 hours. The mass was weighed, which is referred to as $W_2$. Using these values, the coefficient of moisture absorption was determined from the following formula.

$$\text{Coefficient of moisture absorption (\% by weight)} = ((W_2-W_0)/W_0) \times 100$$

(Weather resistance test)

The obtained non-combustible film was allowed to stand in a thermostat bath at 85°C and 85%RH. The film was taken out of the bath after an elapse of time shown in Table 1, for observation of the appearance and other properties. As a result, the weather resistance of a film without discoloration or peeling on the surface or cross-section was evaluated as "good", and the weather resistance of a film with discoloration or peeling on the surface or cross-section was evaluated as "bad".

[Table 4]

| | | | | Example 1 | Example 2 | Example 3 | Example 4 | Example 5 |
|---|---|---|---|---|---|---|---|---|
| Dispersion liquid for non-combustible films | Composition (parts by weight) | Water-insoluble inorganic compound | Talc | 6.0 | 2.7 | 3.0/6.0/3.0 (dispersion liquid 1/dispersion liquid 2/dispersion liquid 1) | 7.0 | 6.1 |
| | | | Kaolin | - | - | - | - | - |
| | | | Non-swelling mica | - | - | - | - | - |
| | | | Alumina | - | - | - | - | - |
| | | Precursor of synthetic resin | Polyamic acid | 3.7 | 3.7 | 7.0/4.0/7.0 (dispersion liquid 1/dispersion liquid 2/dispersion liquid 1) | 3.0 | 4.1 |
| | | Dispersion medium | N-methyl-2-pyrrolidone | 16.3 | 16.3 | 30.6/17.5/30.6 (dispersion liquid 1/dispersion liquid 2/dispersion liquid 1) | - | - |
| | | | N,N-dimethylacetamide | - | - | - | 14.8 | 20.9 |
| | Non-volatile component content in total weight of dispersion liquid (% by weight) | | | 37.3 | 28.2 | 24.6/36.4/24.6 (dispersion liquid 1/dispersion liquid 2/dispersion liquid 1) | 40.3 | 32.8 |
| | Water-insoluble inorganic component content in total non-volatile components (% by weight) | | | 61.9 | 42.2 | 30-6/60.0/30.0 (dispersion liquid 1/dispersion liquid 2/dispersion liquid 1) | 70.0 | 59.8 |

(continued)

| | | | | Example 1 | Example 2 | Example 3 | Example 4 | Example 5 |
|---|---|---|---|---|---|---|---|---|
| Non-combustible film | Composition (parts by weight) | Water-insoluble inorganic compound | Talc | 6.0 | 2.7 | 3.0/6.0/3.0 (first layer/second layer/third layer) | 7.0 | 6.1 |
| | | | Kaolin | - | - | - | - | - |
| | | | Non-swelling mica | - | - | - | - | - |
| | | | Alumina | - | - | - | - | - |
| | | Synthetic resin | Polyimide resin | 3.7 | 3.7 | 7.0/4.0/7.0 (first layer/second layer/third layer) | 3.0 | 4.1 |
| | Water-insoluble inorganic component content in total weight of film (% by weight) | | | 61.9 | 42.2 | 50.0 (30.0/60.0/30.0) Total (first layer/second layer/third layer) | 70.0 | 59.8 |
| | Film appearance | | | Uniform | Uniform | Uniform | Uniform | Uniform |
| | Film thickness (μm) | | | 80 | 80 | 120 | 110 | 90 |
| Evaluation | Flame retardancy | | VTM test | Passed with VTM-0 | Passed with VTM-0 | Passed with VTM-0 | Passed with VTM-0 | Passed with VTM-0 |
| | | | V test | Passed with V-0 | Passed with V-0 | Passed with V-0 | Passed with V-0 | Passed with V-0 |
| | | | 5V test | Passed with 5VB | Passed with 5VB | Passed with 5VB | Passed with 5VB | Passed with 5VB |
| | Non-combustibility | | Rolling stock material combustion test | Non-combustible | Non-combustible | Non-combustible | Non-combustible | Non-combustible |
| | Cone calorimeter test | | Total heat release ($MJ/m^2$) | 0.83 | 0.98 | 2.23 | 1.15 | 1.50 |
| | | | Maximum heat release ($kW/m^2$) | 3.44 | 4.38 | 7.39 | 3.42 | 5.02 |
| | | | Ignition start time | No ignition | No ignition | No ignition | No ignition | No ignition |
| | Heat shrinkage rate (%) | | | -0.08 | 0.09 | 0.29 | 0.04 | 0.04 |
| | Coefficient of linear expansion ($K^{-1}$) | | | $1.2x10^{-5}$ | $2.6x10^{-5}$ | $1.5x10^{-5}$ | $1.1x10^{-5}$ | $1.8x10^{-5}$ |

(continued)

| | | | Example 1 | Example 2 | Example 3 | Example 4 | Example 5 |
|---|---|---|---|---|---|---|---|
| | Flex resistance | Mandrel diameter (mm) | 1 | ≤ 1 | 2 | 3 | 1 |
| | Tear strength (N/mm) | | 39 | 52 | 116 | 34 | 44 |
| | Tensile strength ($N/mm^2$) | | 44 | 62 | 65 | 35 | 48 |
| | Dielectric breakdown voltage (kV/mm) | | 57 | 52 | 73 | 47 | 50 |
| | Water vapor permeability ($g/m^2$ day) | | 0.3 | 1.2 | 1.1 | 20 | 0.4 |
| | Coefficient of water absorption (% by weight) | | 0.8 | 1.2 | 1.0 | 0.9 | 0.7 |
| | Coefficient of moisture absorption (% by weight) | | 0.6 | 0.9 | 0.9 | 0.3 | 0.7 |
| | Weather resistance (time for standing in thermostat bath at 85°C, 85% RH is shown in parentheses) | | Good (7000 hrs) | Good (7000 hrs) | Good (6500 hrs) | Good (6500 hrs) | - |

[Table 5]

| | | | | Example 6 | Example 7 | Example 8 | Example 9 | Example 10 | Example 11 |
|---|---|---|---|---|---|---|---|---|---|
| Dispersion liquid for non-combustible films | Composition (parts by weight) | Water-insoluble inorganic compound | Talc | 2.8 | 1.6 | 14.9 | - | - | - |
| | | | Kaolin | - | - | - | 5.6 | - | - |
| | | | Non-swelling mica | - | - | - | - | 5.6 | - |
| | | | Alumina | 2.8 | - | - | - | - | 5.6 |
| | | Precursor of synthetic resin | Polyamic acid | 3.7 | 3.7 | 3.7 | 3.7 | 3.7 | 3.7 |
| | | Dispersion medium | N-methyl-2-pyrrolidone | 20.5 | 16.3 | 27.6 | 19.1 | 19.5 | 17.5 |
| | | | N,N-dimethylacetamide | - | - | - | - | - | - |
| | Non-volatile component content in total weight of dispersion liquid (% by weight) | | | 31.2 | 24.5 | 40.3 | 32.7 | 32.3 | 34.7 |
| | Water-insoluble inorganic component content in total non-volatile components (% by weight) | | | 60.2 | 30.2 | 80.1 | 60.2 | 60.2 | 60.2 |
| Non-combustible film | Composition (parts by weight) | Water-insoluble inorganic compound | Talc | 2.8 | 1.6 | 14.9 | - | - | - |
| | | | Kaolin | - | - | - | 5.6 | - | - |
| | | | Non-swelling mica | - | - | - | - | 5.6 | - |
| | | | Alumina | 2.8 | - | - | - | - | 5.6 |
| | | Synthetic resin | Polyimide resin | 3.7 | 3.7 | 3.7 | 3.7 | 3.7 | 3.7 |
| | Water-insoluble inorganic component content in total weight of film (% by weight) | | | 60.2 | 30.2 | 80.1 | 60.2 | 60.2 | 60.2 |
| | Film appearance | | | Uniform | Uniform | Uniform | Uniform | Uniform | Uniform |
| | Film thickness (μm) | | | 100 | 90 | 90 | 110 | 100 | 110 |

(continued)

| | | | Example 6 | Example 7 | Example 8 | Example 9 | Example 10 | Example 11 |
|---|---|---|---|---|---|---|---|---|
| Evaluation | Flame retardancy | VTM test | Passed with VTM-0 | Passed with VTM-0 | Passed with VTM-0 | Passed with VTM-0 | Passed with VTM-0 | Passed with VTM-0 |
| | | V test | Passed with V-0 | Passed with V-0 | Passed with V-0 | Passed with V-0 | Passed with V-0 | Passed with V-0 |
| | | 5V test | Passed with 5VB | Passed with 5VB | Passed with 5VB | Passed with 5VB | Passed with 5VB | Passed with 5VB |
| | Non-combustibility | Rolling stock material test combustion | Non-combusitble | Non-combustible | Non-combustible | Non-combustible | Non-combustible | Non-combustible |
| | Cone calorimeter test | Total heat release ($MJ/m^2$) | 1.25 | 2.00 | 0.80 | 3.08 | 1.06 | 1.37 |
| | | Maximum heat release ($kW/m^2$) | 5.35 | 7.55 | 2.67 | 8.63 | 5.67 | 7.72 |
| | | Ignition start time | No ignition | No ignition | No ignition | No ignition | No ignition | No ignition |
| | Heat shrinkage rate (%) | | 0.54 | 0.40 | 0.09 | 0.03 | 0.07 | 0.15 |
| | Coefficient of linear expansion ($K^{-1}$) | | $2.1x10^{-5}$ | $2.4x10^{-5}$ | $2.4x10^{-5}$ | $0.8x10^{-5}$ | $1.5x10^{-5}$ | $4.0x10^{-5}$ |
| | Flex resistance | Mandrel diameter (mm) | 2 | $\leq 1$ | 5 | 8 | 7 | 2 |
| | Tear strength (N/mm) | | 61 | 130 | 33 | 49 | 50 | 110 |
| | Tensile strength ($N/mm^2$) | | 79 | 94 | 39 | 86 | 96 | 132 |
| | Dielectric breakdown voltage (kV/mm) | | 59 | 63 | 43 | 57 | 98 | 77 |
| | Water vapor permeability ($g/m^2 \cdot day$) | | 0.5 | 1.5 | 0.4 | 0.5 | 0.2 | 0.8 |
| | Coefficient of water absorption (% by weight) | | 0.8 | 1.0 | 0.5 | 1.5 | 1.1 | 1.0 |
| | Coefficient of moisture absorption (% by weight) | | 0.6 | 0.9 | 0.4 | 0.9 | 0.9 | 0.6 |
| | Weather resistance (time for standing in thermostat bath at 85°C, 85%RH is shown in parentheses) | | - | - | - | - | - | - |

[Table 6]

| | | | | Example 12 | Example 13 |
|---|---|---|---|---|---|
| Dispersion for non-combustible films | Composition (parts by weight) | Water-insoluble inorganic compound | Talc | 9.2 | 10.7 |
| | | | Kaolin | - | - |
| | | | Non-swelling mica | - | - |
| | | | Alumina | - | - |
| | | Precursor of synthetic resin | Polyamic acid | 6.1 | 7.2 |
| | | Dispersion medium | N-methyl-2-pyrrolidone | - | - |
| | | | N,N-dimethylacetamide | 68.9 | 50.8 |
| | Non-volatile component content In total weight of dispersion liquid (% by weight) | | | 18.2 | 26.1 |
| | Water-insoluble inorganic component content in total non-volatile components (% by weight) | | | 60.1 | 59.8 |
| Non-combustible film | Composition (parts by weight) | Water-insoluble inorganic compound | Talc | 9.2 | 10.7 |
| | | | Kaolin | - | - |
| | | | Non-swelling mica | - | - |
| | | | Alumina | - | - |
| | | Synthetic resin | Polyimide resin | - | 3.6 |
| | | | Polybenzoxazole resin | 6.1 | 3.6 |
| | Water-insoluble inorganic component content In total weight of film (% by weight) | | | 60.1 | 59.8 |
| | Film appearance | | | Uniform | Uniform |
| | Film thickness (μm) | | | 70 | 60 |
| Evaluation | Flame retardancy | | VTM test | Passed with VTM-0 | Passed with (VTM-0 |
| | | | V test | Passed with V-0 | Passed with V-0 |
| | | | 5V test | - | - |
| | Non-combustibility | | Rolling stock material combustion test | - | - |
| | Cone calorimeter test | | Total heat release ($MJ/m^2$) | - | - |
| | | | Maximum heat release ($kW/m^2$) | - | - |
| | | | Ignition start time | - | - |
| | Heat shrinkage rate (%) | | | 0.15 | 0.10 |
| | Coefficient of linear expansion ($K^{-1}$) | | | $0.1x10^{-5}$ | $0.7x10^{-5}$ |
| | Flex resistance | | Mandrel diameter (mm) | 3 | 2 |

(continued)

| | | Example 12 | Example 13 |
|---|---|---|---|
| | Tear strength (N/mm) | - | - |
| | Tensile strength ($N/mm^2$) | - | - |
| | Dielectric breakdown voltage (kV/mm) | - | - |
| | Water vapor permeability ($g/m^2$ day) | 0.7 | 0.3 |
| | Coefficient of water absorption (% by weight) | - | - |
| | Coefficient of moisture absorption (% by weight) | - | - |
| | Weather resistance (time for standing in thermostat bath at 85°C, 85%RH is shown in parentheses) | - | - |

(Example 14)

The dispersion liquid for non-combustible films obtained in Example 1 was applied by a doctor blade to a polypropylene sheet having a smooth, rectangular bottom face, to a thickness of 300 μm. The dispersion liquid was dried in a 50°C forced air oven for 10 hours with the polypropylene sheet held in a horizontal position, so that a film was formed on the polypropylene sheet. To the film formed on the polypropylene sheet, the dispersion liquid for non-combustible films obtained in Example 1 was applied by a doctor blade again to a thickness of 300 μm. The dispersion liquid was dried in a 50°C forced air oven for 10 hours with the polypropylene sheet held in a horizontal position, so that a film was formed on the polypropylene sheet. The films were peeled off the polypropylene sheet, and heated at 120°C for 30 minutes, at 150°C for 5 minutes, at 200°C for 5 minutes, and at 350°C for 30 minutes. Thereby, a 120-μm-thick non-combustible film made of talc and a polyimide resin with a talc content of 61.9% by weight of the total weight of the film was produced.

<Evaluation>

(Partial discharge test)

The non-combustible films produced in Example 3 and Example 14 were subjected to the partial discharge test in accordance with IEC61730-2:2004, item 11.1. Specifically, the partial discharge voltage was determined by the following procedure using a measuring device DAC-PD-7 (from Soken Electric Co., Ltd.).

As a result, the partial discharge voltage of the non-combustible film obtained in Example 3 was 2531 V, and the partial discharge voltage of the non-combustible film obtained in Example 12 was at least 3000 V which is the measurement limit.

Measurement procedure

1. The specimen was disposed between the electrodes.
2. Voltage was applied, and the voltage Uinc (vrms) at which partial discharge started was determined. Here, the partial discharge magnitude for the determination was 3 pC.
3. A voltage 1.1 times the Uinc voltage was applied for 10 seconds, and the voltage was immediately dropped until the partial discharge stopped. Here, the partial discharge magnitude for the determination was 1 pC or less. Application of the voltage at which the partial discharge stopped was maintained for 60 seconds. If no partial discharge occurred, the voltage was recorded as Uext voltage (vrms), and the test was ended.
4. The above procedure was performed on ten specimens. Based on the test results, the partial discharge voltage Usys (VDC) was determined from the following formula.

$$\text{Usys} = (\text{average-standard deviation of Uext}) \times \sqrt{2}/(1.2 \times 1.25)$$

(Production of solar cell module and performance evaluation)

Tab wires (6-mm width) were soldered to connect pairs of two strings of 156-mm-square c-Si cells in series, so that solar cells were produced. A sealing material EVA ("Sanvic FC" from Sanvic Inc., 40-cm square) was disposed on a glass plate (from Asahi Glass Co., Ltd., 40-cm square). On the sealing material, the solar cells were placed. A sealing material EVA having a slit allowing mounting terminals to pass was put on the cells. The film produced in Example 14 was then placed on the sealing material as a back sheet. The laminate was heat-compressed at 130°C using a laminator. The EVA protruding out of the end of the heat-compressed plate was removed by an electric cutter. Aluminum frames each with a sealant put into its groove ("SH780 sealant" from Dow Corning Toray Co., Ltd.) were fitted to the four corners of the plate and fixed using screws. The sealant was air-dried at room temperature, and then the ends of the product were sealed. After drying of the sealant, a terminal box (from Onamba Co., Ltd.) was attached to the back sheet such that the mounting terminals were covered. The box was air-dried at room temperature, and the mounting terminals were soldered onto the terminal box. A potting agent (PV-7321 from Dow Corning Toray Co., Ltd.) in an amount of 30 g (mixture of a base agent and a curing agent mixed at 10:1) was poured into the terminal box, and air-dried. The product was left to stand for about one week. A cover for the terminal box was attached. Thereby, a solar cell module was completed. The front surface picture of the solar cell module is shown in Fig. 2(a), and the back surface picture thereof is shown in Fig. 2(b).

The performance of the obtained solar cell module was evaluated. The module showed a fill factor (FF) of about 0.7 in the I-V characteristics evaluation, which means that the module functions as a solar cell without any problem.

INDUSTRIAL APPLICABILITY

The present invention provides a non-combustible film having excellent flexibility, excellent moisture resistance, and high mechanical strength. The present invention also provides a dispersion liquid for non-combustible films which is used in production of the above non-combustible film, a method for producing a non-combustible film using the dispersion, and a solar cell back sheet and a flexible board each of which is formed from the above non-combustible film. The present invention further provides a solar cell including the solar cell back sheet.

Furthermore, the non-combustible film of the present invention, having sufficient mechanical strength, excellent flexibility, and excellent non-combustibility, is usable as a component of materials including various electric materials and machinery materials, such as capacitor dielectrics, substrates for various sensors, insulating films for cells, insulating films for capacitors, various laminated plates, form films, non-combustible cloth, non-combustible building materials, and industrial packings. The present invention provides a new material in these fields, contributing to development to new technologies.

REFERENCE SIGNS LIST

1 Solar cell
2 Solar cell element
3 Sealing material
4 Light-transmissive substrate
5 Solar cell back sheet

**Claims**

1. A non-combustible film comprising
a water-insoluble inorganic compound and
a heat-resistant synthetic resin,
the water-insoluble inorganic compound constituting from 30% by weight to 90% by weight inclusive of the total weight of the non-combustible film,
the film exhibiting a flammability of VTM-0 in the UL-94 VTM test.

2. The non-combustible film according to claim 1,
wherein the water-insoluble inorganic compound is at least one selected from the group consisting of silica compounds, silica-alumina compounds, aluminum compounds, calcium compounds, and nitrides.

**3.** The non-combustible film according to claim 2, wherein the water-insoluble inorganic compound is a phyllosilicate mineral.

**4.** The non-combustible film according to claim 3, wherein the phyllosilicate mineral is a non-swelling clay mineral.

**5.** The non-combustible film according to claim 4, wherein the non-swelling clay mineral is at least one selected from the group consisting of talc, kaolin, pyrophyllite, and non-swelling micas.

**6.** The non-combustible film according to claim 1, 2, 3, 4, or 5, wherein the heat-resistant synthetic resin is at least one selected from the group consisting of polyimide resins, polyamide-imide resins, and polybenzoxazole resins.

**7.** The non-combustible film according to claim 1, 2, 3, 4, 5, or 6, wherein the heat-resistant synthetic resin is at least one selected from the group consisting of aromatic polyimide resins, aromatic polyamide imide resins, and aromatic polybenzoxazole resins.

**8.** The non-combustible film according to claim 1, 2, 3, 4, 5, 6, or 7, which is a laminated product obtained by uniting at least two films.

**9.** The non-combustible film according to claim 1, 2, 3, 4, 5, 6, 7, or 8, which has a thickness of 10 $\mu$m or more.

**10.** The non-combustible film according to claim 1, 2, 3, 4, 5, 6, 7, 8, or 9, which has a water vapor permeability of 20 g/$m^2$·day or less at 40°C and 90%RH.

**11.** The non-combustible film according to claim 1, 2, 3, 4, 5, 6, 7, 8, 9, or 10, which cracks in a bend test using a cylindrical mandrel in accordance with JIS-K5600-5-1 (1999) when the diameter of the mandrel is 10 mm or less.

**12.** The non-combustible film according to claim 1, 2, 3, 4, 5, 6, 7, 8, 9, 10, or 11, which has a coefficient of linear expansion of $5.0 \times 10^{-5}$/°C or less at from 50°C to 250°C.

**13.** The non-combustible film according to claim 1, 2, 3, 4, 5, 6, 7, 8, 9, 10, 11, or 12, which has non-combustibility defined in a rolling stock material combustion test based on "Ministerial Ordinance to Provide the Technical Standard on Railway", the Ministerial Ordinance No. 151 promulgated by the Ministry of Land, Infrastructure, Transport and Tourism.

**14.** The non-combustible film according to claim 1, 2, 3, 4, 5, 6, 7, 8, 9, 10, 11, 12, or 13,
which has, in a heat release test using a cone calorimeter in accordance with ISO 5660-1,
a total heat release from the area of the sample over 20 minutes from the start of heating of 8 MJ/$m^2$ or less,
a maximum heat release rate from the area of the sample over 20 minutes from the start of heating of 300 kW/$m^2$ or less, and
a time from the start of the test to the ignition of 60 seconds or more.

**15.** The non-combustible film according to claim 1, 2, 3, 4, 5, 6, 7, 8, 9, 10, 11, 12, 13, or 14, which has a thickness of 100 $\mu$m or less in the case of exhibiting a flammability of VTM-0 in the UL-94 VTM test.

**16.** The non-combustible film according to claim 1, 2, 3, 4, 5, 6, 7, 8, 9, 10, 11, 12, 13, 14, or 15, which has a dielectric breakdown voltage of 20 kV/mm or more.

**17.** A dispersion liquid for non-combustible films which is used in production of the non-combustible film according to claim 1, 2, 3, 4, 5, 6, 7, 8, 9, 10, 11, 12, 13, 14, 15, or 16, the dispersion comprising:

a dispersion medium; and
nonvolatile components of a water-insoluble inorganic compound and at least one of a heat-resistant synthetic

resin and a precursor of the heat-resistant synthetic resin,
the water-insoluble inorganic compound constituting from 30% by weight to 90% by weight inclusive of the total weight of the nonvolatile components,
the nonvolatile components constituting more than 18% by weight and 65% by weight or less of the total weight of the dispersion liquid for non-combustible films.

**18.** The dispersion liquid for non-combustible films according to claim 17,
wherein the dispersion medium is at least one selected from the group consisting of N-methyl-2-pyrrolidone, N,N-dimethylformamide, N,N-dimethylacetamide, dimethyl sulfoxide, tetrahydrofuran, and sulfolane.

**19.** A method for producing a non-combustible film, comprising:

a step 1 of preparing the dispersion liquid for non-combustible films according to claim 17 or 18;
a step 2 of spreading the prepared dispersion liquid on a substrate and allowing the substrate to stand; and
a step 3 of removing the dispersion medium from the dispersion liquid spread on the substrate to form a film, and removing the film from the substrate.

**20.** The method according to claim 19,
wherein the step 2 is performed with the dispersion liquid spread to a thickness of 50 $\mu$m or more on the substrate.

**21.** The method according to claim 19 or 20,
wherein the step 3 is performed with a temperature for removing the dispersion medium of 150°C or less.

**22.** The method according to claim 19, 20, or 21,
wherein the substrate is made of glass, polyethylene terephthalate, polyimide, polyethylene, or polypropylene.

**23.** A solar cell back sheet,
which is formed from the non-combustible film according to claim 1, 2, 3, 4, 5, 6, 7, 8, 9, 10, 11, 12, 13, 14, 15, or 16.

**24.** A solar cell comprising
the solar cell back sheet according to claim 23.

**25.** A flexible board,
which is formed from the non-combustible film according to claim 1, 2, 3, 4, 5, 6, 7, 8, 9, 10, 11, 12, 13, 14, 15, or 16.

FIG.1

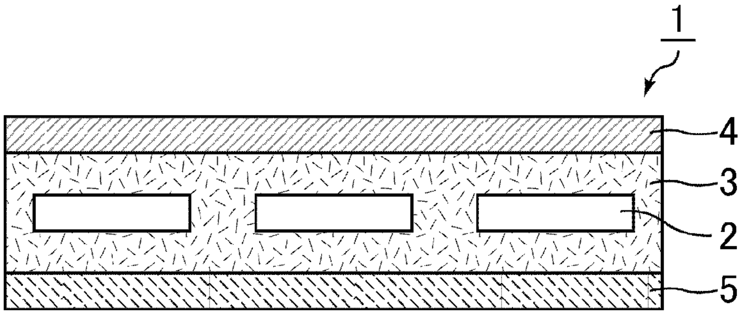


FIG.2

(a)

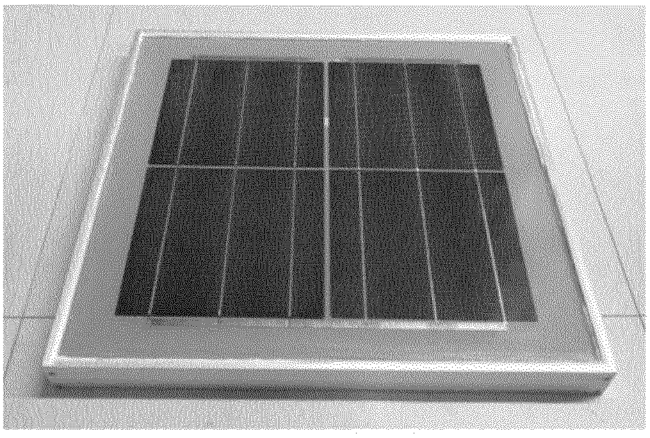

(b)

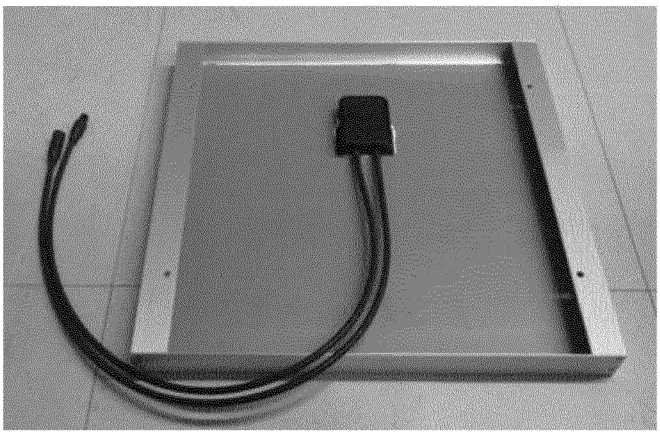

## INTERNATIONAL SEARCH REPORT

International application No.
PCT/JP2012/064699

A. CLASSIFICATION OF SUBJECT MATTER
*C08J5/18*(2006.01)i, *H01L31/042*(2006.01)i, *H05K1/03*(2006.01)i

According to International Patent Classification (IPC) or to both national classification and IPC

B. FIELDS SEARCHED

Minimum documentation searched (classification system followed by classification symbols)
C08J5/18, H01L31/042, H05K1/03

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br><br>Y<br>A | JP 5-275882 A (Kaneka Corp.),<br>22 October 1993 (22.10.1993),<br>claims; paragraphs [0001], [0008] to [0024]<br>(Family: none) | 1,6,7,9,13,<br>15,17-20,25<br>21,22<br>2-5,8,10-12,<br>14,16,23,24 |
| X<br><br>Y<br>A | JP 2009-203414 A (Toray Industries, Inc.),<br>10 September 2009 (10.09.2009),<br>claims; paragraphs [0041] to [0054], [0063] to<br>[0077]<br>(Family: none) | 1-10,13,15,<br>25<br>21,22<br>11,12,14,<br>16-20,23,24 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
30 August, 2012 (30.08.12)

Date of mailing of the international search report
11 September, 2012 (11.09.12)

Name and mailing address of the ISA/
Japanese Patent Office

Facsimile No.

Authorized officer

Telephone No.

Form PCT/ISA/210 (second sheet) (July 2009)

INTERNATIONAL SEARCH REPORT

International application No.
PCT/JP2012/064699

C (Continuation). DOCUMENTS CONSIDERED TO BE RELEVANT

| Category* | Citation of document, with indication, where appropriate, of the relevant passages | Relevant to claim No. |
|---|---|---|
| X | JP 2010-155895 A (Asahi Kasei E-materials Corp.), 15 July 2010 (15.07.2010), claims; paragraphs [0013] to [0038], [0045], [0048] to [0057], [0061], [0069] to [0072], [0098] to [0104] & US 2010/0167022 A1 & CN 101768357 A & TW 201024376 A | 1,2,6-9,13, 15,25 |
| P,X | JP 2012-082392 A (Toray Industries, Inc.), 26 April 2012 (26.04.2012), claims; paragraphs [0026], [0109] to [0110], [0127] to [0142], [0164] to [0168] (Family: none) | 1,2,8,9,12, 13,15,17-20, 22-25 |
| P,X | JP 2012-011555 A (Toray Industries, Inc.), 19 January 2012 (19.01.2012), claims; paragraphs [0021] to [0022], [0035], [0043] to [0051] (Family: none) | 1,2,6-9,13, 15,16,25 |
| A | JP 2000-087001 A (Sumitomo Bakelite Co., Ltd.), 28 March 2000 (28.03.2000), claims; paragraphs [0020] to [0023] (Family: none) | 1-25 |
| A | JP 2007-297564 A (Du Pont-Toray Co., Ltd.), 15 November 2007 (15.11.2007), claim 6; paragraph [0037] (Family: none) | 14 |

Form PCT/ISA/210 (continuation of second sheet) (July 2009)

**INTERNATIONAL SEARCH REPORT**

International application No.
PCT/JP2012/064699

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

Although the invention of claim 1 and the inventions of claims 2-16, 17-18, 19-22, 23-24 and 25 have a common matter which is relevant to the invention of claim 1, the invention of claim 1 does not have novelty and inventiveness in the light of the contents disclosed in the document 3 (JP 2010-155895 A (Asahi Kasei E-materials Corp.), 15 July 2010 (15.07.2010)) which is cited in this international search report, and therefore, the afore-said common matter is not a special technical feature.

In conclusion, this international application involves multiple inventions which do not comply with unity of invention.

1. ☐ As all required additional search fees were timely paid by the applicant, this international search report covers all searchable claims.
2. ☒ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003340919 A
- JP 2002322292 A
- JP 2003342471 A
- JP 3744634 B
- JP 2010533213 T
- JP 2010533362 T
- JP 2006077237 A
- JP 2008004691 A